# EUROPEAN PATENT SPECIFICATION

(11) **EP 3 775 944 B1**
(45) Date of publication and mention of the grant of the patent: **25.10.2023**
(21) Application number: 19709377.6
(22) Date of filing: 18.02.2019
(51) Int. Cl.: G01R 23/20, G01R 23/16, G01R 31/34, H02H 3/52, H02H 7/08

(54) **SYSTEM AND METHOD FOR MONITORING AN OPERATING CONDITION OF AT LEAST ONE ELECTRICAL DEVICE USING A DATA SERVER ARRANGEMENT**
SYSTEM UND VERFAHREN ZUR ÜBERWACHUNG EINES BETRIEBSZUSTANDES MINDESTENS EINER ELEKTRISCHEN VORRICHTUNG UNTER VERWENDUNG EINER DATENSERVERANORDNUNG
SYSTÈME ET PROCÉDÉ POUR SURVEILLER UNE CONDITION DE FONCTIONNEMENT D'AU MOINS UN DISPOSITIF ÉLECTRIQUE À L'AIDE D'UN AGENCEMENT DE SERVEUR DE DONNÉES

(30) Priority: 18.02.2018 GB 201802620
(43) Date of publication of application: 17.02.2021
(73) Proprietor: Faraday Predictive Limited, Cambridge Cambridgeshire CB4 0WS (GB)
(72) Inventor: BATES, Andrew, Baltonsborough BA6 8QY (GB); WALKER, Geoffrey, Kent TN3 0BA (GB); BOULTON, William, CAMBRIDGE Cambridgeshire CB1 2QF (GB); BANNISTER, Myles, Kent TN17 2HL (GB); ALFEIRAN, Bran, 08003 Barcelona (ES)
(74) Representative: Basck Limited
(86) International application number: PCT/EP2019/053976
(87) International publication number: WO 2019/158754

(56) References cited:
- US-A- 4 761 703
- US-A1- 2003 001 747
- US-A1- 2010 169 030
- US-A1- 2013 030 765

## Description

### TECHNICAL FIELD

The present disclosure relates generally to monitoring electrical devices, and more specifically, a system and method that uses a data server arrangement for monitoring an operating condition of at least one electrical device based on measurement of voltage or current, or both, drawn by the at least one electrical device (for example, an electrical motor, an electrical linear actuator), or generated by the at least one electric device (for example, an electrical generator, a photovoltaic panel, a tidal electrical generator, a heliostat electrical generator, a wind turbine electrical generator). Moreover, the present disclosure relates to a computer program product comprising a non-transitory computer-readable storage medium having computer-readable instructions stored thereon, the computer-readable instructions being executable by a computerized device comprising processing hardware to execute the aforesaid method. Embodiments of the present disclosure concern a type of technology that is capable of reducing Carbon Dioxide (CO₂) emissions, as a result of improving operation of electrical devices, for example electrical machines, at higher efficiency and avoiding unnecessary maintenance.

### BACKGROUND

An example electrical device transforms electrical energy, defined by electrical current and voltage, into another form of energy for example light energy, heat energy, or motional (kinetic) energy (e.g. a refrigerator, a vacuum cleaner, a washing machine, a pump, an electrical motor, a fan etc.) or *vice versa* (e.g. an electrical generator). Electrical devices are widely used in domestic and industrial applications. The electrical devices are typically used, for example, to move goods along an assembly line from one work station to another, as a power source for power tools used by assemblers when constructing items, and to operate any machine tools. Examples include larger high-horsepower electrical motors that maintain environmental control by cooling, heating and transporting air through heating and cooling systems in buildings, industries and safety-critical systems, for example cooling systems for power stations (for example, small modular high-temperature gas-cooled fission reactors), molten salt pumps for Thorium fission reactors (LFTR), crop irrigation, fire prevention systems (for example on oil and gas platforms) and such like. In home and office environments, the electrical motors are used in appliances ranging from refrigerators, air conditioners, computers to vacuum cleaners, washing machines, lift (elevator) motors etc. After many hours of operation, or as a result of such electrical devices being stressed beyond their design limits, various faults potentially develop due to continuous operation, temporally intermittent heavy load, shortage in electrical supply, over current or voltage and so forth. Due to such potential faults, repair, replacement or other maintenance of electrical devices is required to be implemented. In the manufacturing industry, unexpected failure of the electrical device is both undesirable and costly and could have significant financial impact if an assembly line is shut down during the time it takes to repair or replace the electrical device. However, unnecessary shutdown and replacement of an electrical device in manufacturing industry is also very costly for businesses, and wasteful in human time and materials. Similar considerations pertain when the electrical device is a generator, for example a generator of a remote wind turbine, tidal energy turbine, wave energy turbine, solar thermal power generator, hydroelectric generator, and similar.

Existing known monitoring systems and methods that are employed for monitoring electrical devices are cumbersome, expensive and/or are limited to identifying only a few failure modes of the electrical devices. Furthermore, the existing known monitoring systems and methods are inaccurate in prognosing and/or diagnosing potential problems or faults. One such existing monitoring system employs vibration analysis, which is used to detect faults in rotating equipment (e.g., fans, motors, pumps, gearboxes etc.) such as unbalance, misalignment, rolling element bearing faults, and resonance conditions. Another known existing monitoring system employs electrical motor current signature analysis (MCSA) that measures current on a single electrical phase or three electrical phases of an electrical motor to monitor an operating condition of the electrical motor. However, this existing system is not capable of dealing with distorted voltages and has limited fault-type application.

Known model-based voltage and current (MBVI) systems are inflexible, have limited diagnostic capability and provide a high level of false alerts, resulting in a need for expert interpretation of their analysis outputs. Furthermore, known model-based voltage and current (MBVI) systems are often too difficult to deploy due to their inflexible connection and configuration abilities. Such a combination of high costs for typical model-based voltage and current (MBVI) systems, installation challenges, and the cost of expert interpretation render them too expensive for widespread adoption.

Therefore, in light of the foregoing discussion, there exists a need to overcome the aforementioned drawbacks in existing systems and methods for monitoring an operating condition of an electrical device.

In a published United States patent application US2006/0139031A1; *"Sensor for sensing an electric field";* inventors Kalokitis (US), Zalud (US), Berends (US), Polyzois (US), Vannozzi (US) and Lang (US); applicant Power Survey Company (US); there is described a sensor for sensing an electric field, wherein the sensor includes a movable sensor probe including one or more pairs, typically three pairs, of electrically conductive electrodes, and includes one or more pairs of selectively switchable auxiliary electrodes. The probe is movable and is mountable on a vehicle or trailer. A processor processes electric field signals obtained in operation from the probe for providing a humanly-perceivable indication of the electric field. The processor performs a Fast Fourier Transform of the electric field signals to produce an indication of a magnitude of the electric field, and performs unweighted and/or weighted averaging in relation to processing electric field data, setting a comparison threshold, providing a humanly-perceivable indication, or a combination of the foregoing. A speed at which the sensor probe is moving is utilized in processing the data.

In a published Chinese patent application CN104375005A; *"Networked wind power plant harmonic wave monitoring system and method"*; inventors Goa (CN), Chen (CN), Zhang (CN), Huang (CN), Zhang (CN), Song (CN); applicants State Grid Ningxia Electric Power Co., Electric Power Research Institute; there is described a networked wind power plant harmonic wave monitoring system and method. The system comprises a master station and at least one secondary station. Each secondary station is used for collecting voltage data and current data of a monitoring point and conducting harmonic wave calculations according to the collected voltage data and the collected current data; calculated harmonic wave data are transmitted to the master station. The master station is in charge of storing, statistics and analyzing the harmonic wave data and executing harmonic wave out-of-limit warning. The wind power plant harmonic wave monitoring system comprises the master station and the secondary stations, wherein the secondary stations are used for completing data collection, and harmonic wave calculation and harmonic wave data uploading. Moreover, the master station is used for completing storing, statistics and analyzing the harmonic wave data and executing harmonic wave out-of-limit warning. In this way, the monitoring points of the secondary stations in a wind power plant can be connected into a whole entity, wherein the entity enables networking of harmonic wave online monitoring to be achieved, as well as all-weather and omnidirectional monitoring of harmonic wave conditions of the wind power plant to be achieved. Moreover, a systematic analysis of a forming and failure mechanism of harmonic waves is facilitated by the entity.

In a published United States patent application US5966675A, "Method and device for monitoring power supply networks"; inventor Koeck (DE); applicant Siemens AG; there is described a method for monitoring a power supply network, wherein the method comprises steps of:
(a) periodically sampling and digitizing at least one of a voltage and a current to generate sampling values;
(b) detecting a fault;
(c) recording a number of sampling values before, during and after the fault;
(d) compressing the number of recorded sampling values;
(e) generating spectral values from an integer multiple of the number of recorded sampling values using a discrete Fourier transformation;
(f) comparing amplitudes of the spectral values with a threshold value; selecting those spectral values whose amplitudes are greater than the threshold value;
(g) transmitting or storing the selected spectral values;
(h) replacing those spectral values whose amplitudes are not greater than the threshold value with constant values that are smaller than the threshold value; and
(i) performing an inverse discrete Fourier transformation using the selected spectral values and the constant values.

Spectral values are calculated from sampling values of the network voltage or current using the discrete Fourier transformation. Of these values, only those that are greater than a predefined threshold value (SW) are transmitted or stored. The missing spectral values are assumed to be equal to zero to reconstruct the sampling values. In general, only those spectral values are transmitted or stored that pertain to a fault and its previous and subsequent history of a few seconds.

In a published United States patent application US4709339A; *"Electrical power line parameter measurement apparatus and systems, including compact, line-mounted modules"*; inventor and application Fernandes (US); there is described a system including sensor modules for mounting directly upon energized electrical power lines to monitor parameters associated with operation thereof. The modules include a first, cylindrical housing portion containing sensing arrangements and other electronic data processing and transmitting elements, and a second housing portion, affixed to the exterior of the first portion and extending not more than about an angle of 150° around the periphery thereof, and enclosing mechanical elements of a module mounting arrangement. The system provides, when in operation, an improved accuracy of voltage measurements made by such modules by compensating for effects of adjacent, energized conductors, an arrangement for reducing the number of frequency channels required for RF data transmissions by a large number of sensor modules at a substation, an arrangement for acquiring time-synchronized data from multiple modules within a substation for accurate post-fault, sequence-of-events analysis, an arrangement for performing high speed sampling and comparison of cyclically variable parameters for relaying and harmonic measurement applications, and optical communications links for transmitting data from sensor modules.

The US patent document US 4 761 703 A discloses a method and apparatus for detecting rotor faults in an induction motor. The patent documents US 2010/169030 A1, US 2013/030765 A1, and US 2003/001747 A1 disclose additional arrangements to carry out frequency analysis.

### SUMMARY

The present disclosure seeks to provide improved systems for monitoring operating conditions of electrical devices that are less susceptible to providing false positives in respect of potential faults. In this respect, an electrical condition monitoring system is defined in the independent claim 1. Further embodiments are defined in the corresponding dependent claims 2-13.

Moreover, the present disclosure seeks to provide improved methods for (of) monitoring operating conditions of electrical devices that are less susceptible to providing false positives in respect of potential faults. In this respect, a method of using the electrical condition monitoring system of the invention is defined in the independent claim 14.

The present disclosure also provides a computer program product comprising a non-transitory computer-readable storage medium having computer-readable instructions stored thereon to cause the system of claim 1 to execute all the steps of the method of claim 14.

Embodiments of the present disclosure substantially eliminate or at least partially address the aforementioned drawbacks in existing systems and methods for monitoring an operating condition of an electrical device. Additional aspects, advantages, features and objects of the present disclosure are presented by the drawings and the detailed description for the better understanding of the embodiments of the invention defined by the appended claims.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:
FIG. 1 is a schematic illustration of an electrical condition monitoring system in accordance with an embodiment of the present disclosure;
FIG. 2 is a functional block diagram of a data server arrangement in accordance with an embodiment of the present disclosure;
FIG. 3 is an exemplary view of a graphical user interface of an electrical condition monitoring system in accordance with an embodiment of the present disclosure;
FIG. 4 is an exemplary view of a graphical user interface of an electrical condition monitoring system that depicts operating conditions of an electrical device in accordance with an embodiment of the present disclosure;
FIG. 5 is an exemplary view of a graphical user interface of an electrical condition monitoring system that depicts an identification of peaks (e.g. local maxima) in a temporally-changing Fourier spectrum in accordance with an embodiment of the present disclosure;
FIG. 6 is an exemplary view of a graphical user interface of an electrical condition monitoring system that depicts suggestions pertaining to a fault detected in a belt drive of an electrical device in accordance with an embodiment of the present disclosure;
FIG. 7 is an exemplary view of a graphical user interface of an electrical condition monitoring system that depicts automatic identification an operating condition of a rotor bar in accordance with an embodiment of the present disclosure;
FIG. 8 is an exemplary view of a graphical user interface of an electrical condition monitoring system that depicts automatic identification of energy wastage in an electrical device in accordance with an embodiment of the present disclosure;
FIGS. 9A and 9B are exemplary tabular views that depict detection of faults in an electrical device using an electrical condition monitoring system in accordance with an embodiment of the present disclosure; and
FIGS. 10A to 10E are flow diagrams illustrating a method in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

The present disclosure provides an electrical condition monitoring system, characterized in that the electrical condition monitoring system includes a data server arrangement that is connectable via a data communication network arrangement to at least one monitoring unit that is spatially local to a corresponding at least one electrical device, and that is configured to monitor the at least one electrical device when the at least one electrical device is in operation, wherein:
(i) the at least one monitoring unit includes a sensing arrangement that temporally senses electrical signals associated with the at least one electrical device and generates corresponding sensed data by processing the sensed electrical signals associated with the at least one electrical device, wherein the sensed data includes information associated with at least one of a supply of voltage or a supply of current to and/or from the at least one electrical device;
(ii) the at least one monitoring unit connected with the at least one electrical device, wherein the at least one monitoring unit includes a data processing arrangement including a data processor that is configured to
   - process the sensed data to generate a corresponding temporally-changing Fourier spectrum including signal harmonic components for at least one of the current or the voltage that is supplied to and/or from the at least one electrical device; optionally, there are included signal harmonic components for at least one of the current or the voltage that is supplied to and/or from the at least one electrical device or of a calculated residual current or voltage; and
   - process temporal changes in magnitudes and frequencies of the signal harmonic components to generate analysis data representative of operation of the at least one electrical device; and
(iii) the at least one monitoring unit is configured to communicate the analysis data to the data server arrangement to perform at least one of:
   (a) aggregating the analysis data received from the at least one monitoring unit to obtain aggregated analysis data;
   (b) generating aggregated performance results in respect of the at least one electrical device based on the aggregated analysis data;
   (c) providing control signals to at least one monitoring unit to monitor operation of the at least one electrical device based on the aggregated performance results of the at least one electrical device;
   (d) generating alerts relating to the at least one electrical device when the aggregated performance results of the at least one electrical device exceeds a threshold level, wherein the alerts represent at least one of: maintenance required for the at least one electrical device, replacement required for different parts of the at least one electrical device or potential causes for failure of the at least one electrical device; and
   (e) generating a condition assessment of the at least one electrical device, wherein a condition of the at least one electrical device is assessed based on comparison between a real-time model of the at least one electrical device generated based on the analysis data with one or more stored models of the at least one electrical device, optionally of a plurality of electrical devices.

The present system thus monitors the operating condition of the at least one electrical device (e.g. a refrigerator, a vacuum cleaner, a washing machine, a pump, an electrical motor, a fan, a generator, a dynamo, etc.) more accurately than existing known monitoring systems, over a period of time. The present system helps to avoid performing unnecessary maintenance works on the at least one electrical device. The present system can analyze the problems or faults that are developing in the at least one electrical device before they become critical and provide suggestions to solve the problems or faults at a suitable time to avoid unexpected breakdowns of the at least one electrical device. The present system helps, for example, to monitor operating conditions (a *"health"* of the at least one electrical device) of industrial machines such as an industrial fan, an industrial dryer, a fixture (tool), one or more Computer Numerical Control (CNC) machines, one or more generators, one or more wind turbine generators, one or more standby generators, etc. The present system may also help, for example, to monitor operating conditions of household electrical devices such as a refrigerator, a roof mounted fan, an air conditioner, a washing machine, a vacuum cleaner, a generator, a wind turbine, etc.

The present system thus manages processing of at least one of current or voltage measurements, or both, having distortion and infers the sensed data from measured voltage or current signals, or both, despite the voltage and current signals potentially being distorted, for effectively monitoring the operating condition of the at least one electrical device. The present system is more reliable than the existing monitoring systems in detection of problems or faults in the at least one electrical device, thereby avoiding false alarms which can be very disruptive and costly to an industrial facility using the at least one electrical device (e.g. electrical motor). Furthermore, the present system can be easily connected with the electrical system and may not require any configuration changes in the at least one electrical device to deploy it. The present system helps to save the maintenance cost of the at least one electrical device to a larger extent by adopting a condition-based maintenance strategy for the maintenance of the at least one electrical device.

The present system can reduce, for example minimize, energy wastages by promptly analyzing the problems in the at least one electrical device in real-time and quantify benefits based on information associated with energy wastages occurred in the at least one electrical device. The present system, when in operation, is capable of generating a baseline profile (e.g. capability of acceptance of the sensed data, a lifetime of the at least one electrical device etc.) of the at least one electrical device at a Factory Acceptance Test (FAT). The present system optionally performs a subsequent test (e.g. a Post-Installation Test (PIT) or a Commissioning Test) on the at least one electrical device on commissioning thereof to confirm that no damage has occurred during delivery and installation processes of the at least one electrical device. The present system optionally generates automatic written suggestions and graphical reports (e.g. analysis data) that can be edited by a user through the user interface to add any specific information. The present system optionally provides the analysis data to a concerned person whoever the user chooses.

The present system helps, for example, to monitor operating conditions of inaccessible electrical devices such as a submerged pump, a borehole pump, an in-tank pump, a cryogenic pump, a roof mounted pump, a remote wind turbine generator, a remote tidal turbine generator, a remote ocean wave turbine generator, etc. The present system is capable of helping to monitor or test an operating condition of a given electrical device without requiring shutting down or requiring access to the inside of a cabinet of the electrical device in some circumstances. The present system is capable automatically of analyzing faults present in the at least one electrical device and providing suggestions on a nature of the faults, a corrective action required and a timescale in which the corrective action should be taken based on measurements of:
(i) the voltage or the current, or both, supplied to the at least one electrical device (for example, in a situation where the at least one electrical device is an electrical motor); and/or
(ii) the voltage or the current, or both, generated by the at least one electrical device (for example, in a situation where the at least one electrical device is a generator.

For example, the electrical device is optionally implemented as a pump that is able to generate electricity when water flows through it from a water reservoir at an elevated height, and is able to consume electricity when pumping water upwards to refill the water reservoir.

The present system can also monitor the at least one electrical device implemented as a plurality of such electrical devices, while the electrical devices are operating at mutually different speeds and different loads.

The system can identify a wide range of failure modes and assess a degree to which the at least one electrical device is suffering from the failures by generating the sensed data based on the voltage or current, or both, drawn by and/or provided from the at least one electrical device when in operation.

In an embodiment, the at least one monitoring unit is portably connected to the at least one electrical device (e.g. a pump, a compressor, a conveyor, a mixer, a fan, a vacuum cleaner, a washing machine, an electrical motor, an electrical generator) to measure the voltage or the current, or both, that are being drawn by and/or provided from the at least one electrical device when in operation; for example, a first implementation of the at least one monitoring unit is configured only to monitor voltages, whereas a second implementation of the at least one monitoring unit is configured only to monitor currents, whereas a third implementation of the at least one monitoring unit is configured to monitor both currents and voltages. The at least one monitoring unit is optionally connected with, or embedded in (for example embedded to be integral within) a starter of at least one electrical device. The at least one monitoring unit optionally periodically measures the voltage or the current, or both, supplied to and/or provided from the at least one electrical device for monitoring operating conditions of the at least one electrical device.

As aforementioned, the sensing arrangement optionally efficiently measures the voltage or the current, or both, supplied to and/or provided from the at least one electrical device that is operating at different speeds and different loads. The sensing arrangement optionally includes current clamps (e.g. using clamp-on ferrite core current transformers) to measure the current and dolphin connectors or magnetic connectors to measure the voltage supplied to and/or provided from the at least one electrical device. In an embodiment, the at least one monitoring unit is electrically connected to the at least one electrical device for temporally sensing the electrical signals to and/or provided from the at least one electrical device using the sensing arrangement. The sensing arrangement optionally filters and processes the electrical signals (e.g. the supply of voltage or the supply of current, or both) to and/or provided from the at least one electrical device and generate the corresponding sensed data.

The data processor of the at least one monitoring unit optionally generates the temporally-changing Fourier spectrum for at least one of the current or the voltage, (optionally a calculated residual current or residual voltage) by performing a Fourier Transform or similar frequency spectral analysis, for example a Fast Fourier Transform (FFT), on at least one of the current or the voltage (optionally, or residual current or residual voltage) that is supplied to and/or from the at least one electrical device. The analysis data optionally includes a trend graph, for example shown to a given user via a graphical user interface (GUI), showing the changes in magnitudes and frequencies of the signal harmonic components based on the sensed data. The analysis data optionally includes a report that indicates an operating condition of the at least one electrical device. The analysis data is optionally generated in .ppt format, .doc format, XML^{®} format etc. In an embodiment, the data processor of the at least one monitoring unit generates analysis data in a convenient format such as Microsoft Word^{®} that provides a range of information including raw data (e.g. voltage and current waveform of a diagnosis, prognosis, information on the fault and recommended action). In an embodiment, the trend graph includes information related to generic faults and/or specific faults detected in the at least one electrical device, suggestions for faults detected in the at least one electrical device, an operating condition of the at least one electrical device in different time periods, energy wastage occurred due to the faults in the at least one electrical device or bearing data.

In an embodiment, the trend graph is displayed either as the magnitude of a specific line frequency (e.g. the magnitude of 40 Hertz (Hz) peak) or the magnitude of a highest peak or local maximum in the family of locations corresponding to the same underlying phenomenon (e.g. a 10 Hz phenomenon occurring in the at least one electrical device that is fed by a supply with a frequency of 50Hz may show up on the temporally-changing Fourier spectrum at either 40Hz (50Hz - 10 Hz) or 60 Hz (50 Hz + 10 Hz). Sometimes it may also appear as sidebands on higher harmonics of line frequency, such as 90 Hz or 110Hz (i.e. 2*50 Hz +/-10 Hz), at 140 Hz or 160 Hz (i.e. 3*50 Hz +/- 10 Hz) or at 190 Hz or 210 Hz (i.e. 4*50 Hz +/- 10 Hz), etc. The trend graph is optionally plotted based on a highest peak (namely largest magnitude peak) in such a family of peaks. In an embodiment, when identifying the highest peak or local maximum in the family of possible peaks or local maxima, the magnitude of the highest peak is optionally determined based on either the absolute magnitude of the highest peak, or the magnitude relative to a height (for example, when displayed on a graph) of that peak during the base-lining process or the magnitude relative to an average from a number of other electrical devices that are being used for comparison purposes. The magnitude of the peak is optionally calculated either on absolute numbers or number of standard deviations.

The control signals that is received from the data server arrangement optionally trigger the at least one monitoring unit to measure the supply of voltage or the supply of current, or both, provided to and/or from the at least one electrical device to monitor an operating condition of the at least one electrical device. The control signals optionally include information associated with a time period at which the at least one monitoring unit needs to measure the supply of voltage or the supply of current, or both, provided to and/or from the at least one electrical device. The data server arrangement optionally controls the at least one monitoring unit to monitor the at least one electrical device.

The data server arrangement optionally generates alerts relating to the at least one electrical device when a change is detected in an operating condition of the at least one electrical device. The data server arrangement optionally communicates the alerts to the at least one monitoring unit when a change is detected in an operating condition of at least one part of an electrical device. The data server arrangement optionally communicates the alerts to a device of plant historians, plant process control systems, graphical user interfaces (GUI's) of plant operator control unit etc. to provide people an indication in a real time of a current operating condition of the at least one electrical device and determining/indicating whether any problems are developing in the at least one electrical device (e.g. the at least one part of the electrical device). The at least one part of the electrical device is optionally at least one of: a motor rotor, a motor stator, a generator, etc., or any combination thereof.

The data server arrangement optionally generates an automated report for the at least one electrical device that includes at least one of unbalance or misalignment, bearing problems, foundation looseness, transmission looseness or rubbing, motor rotor bars, motor stator problems, generator rotor bars, generator rotor problems, electrical odd harmonics or other spectrum peak beyond normal expected values. The data server arrangement optionally generates a report that includes information on electrical parameters associated with the at least one electrical device which include at least one of: active power, reactive power and power factor, voltage balance, current balance, total harmonic distortion (THD) in the voltage or THD in the current. The condition assessment of the at least one electrical device is optionally a report that represents an operating condition of the at least one electrical device or at least one part of the electrical device.

In an embodiment, the electrical distortion noise optionally includes for example distortion caused due to switching noise, non-linearity noise (e.g. magnetic saturation noise), spark discharge noise, present in the temporally-changing Fourier spectrum, distortion caused due to an operation of the at least one electrical device, or distortion caused due to variations in motor or generator current caused by variations in the at least one electrical device behaviours or distortion caused due to induced noise coming from other electrical devices/equipments.

In an embodiment, the data processing arrangement may be present in the data server arrangement. In an embodiment, the data server arrangement may process the sensed data to generate a corresponding temporally-changing Fourier spectrum including signal harmonic components for the current or voltage, or both, that is supplied to the at least one electrical device (optionally, or for a calculated residual current or residual voltage). The data server arrangement may generate analysis data representative of operation of the at least one electrical device by processing the temporal changes in magnitudes and frequencies of the signal harmonic components.

In an embodiment, the data server arrangement retrieves information pertaining to parameters of the at least one electrical device (e.g. a refrigerator, a vacuum cleaner, a washing machine, a pump, an electrical motor, a fan, a generator, a dynamometer, etc.) from a database of the data server arrangement when the at least one electrical device is previously tested by the data server arrangement. The parameters optionally include nominal voltage, nominal current, nominal supply frequency, nominal rotational speed, number of vanes on impeller, bearing type codes, speed ratios of the number of vanes on a pump, ratios of transmission systems, belt drive dimensions and etc. that is taken from the at least one electrical device.

According to an embodiment, the data server arrangement is operable to provide analysis data to a user interface (for example, a graphical user interface (GUI)) that is configured (namely, is arranged) for user entry of input for analyzing the analysis data and the data server arrangement is configured (namely, is arranged) to analyze the analysis data based on the input to obtain information indicative of an operating condition of the at least one electrical device. The input is optionally a selection of a peak on the temporally-changing Fourier spectrum associated with the sensed data.

According to another embodiment, the data processing arrangement of the at least one monitoring unit is operable to at least partially filter out the changes in magnitudes and frequencies of the signal harmonic components caused due to electrical distortions present in the temporally-changing Fourier spectrum; such electrical distortions can arise, for example, from one or more of:
(i) electronic switching artifacts caused by switching devices such as triacs, thyristors, power FETs, power Silicon Carbide transistors, diodes, power BJT, and so forth;
(ii) poor connections giving rise to intermittent arcing effects, insulation breakdown, stochastic variations in electrical supply source impedance, and so forth;
(iii) magnetic saturation in magnetic components such as motor cores, transformer cores, and so forth; and
(iv) intermittent external sources of spurious electrical signals.

In an embodiment, in order to filter out the changes in magnitudes and frequencies of the signal harmonic components, the data processing arrangement optionally comprises an arrangement for averaging multiple sensed data so that random noise sums to zero on average and leaving the underlying electrical signals. The data processing arrangement optionally identifies changes in magnitudes and frequencies of the signal harmonic components caused due to electrical distortions, for example switching noise or non-linearity noise (e.g. magnetic saturation noise) as aforementioned, to identify the faults associated with the at least one electrical device. The changes in magnitudes and frequencies of the signal harmonic components are optionally identified by analyzing the temporally-changing Fourier spectrum. The signal harmonic components potentially (namely, may) include sub-harmonics, random harmonics and non-integer multiples of line frequency. The signal harmonic components potentially (namely, may) include a first harmonic, a second harmonic, a third harmonic and a fourth harmonic as 1x fundamental frequency, 2x fundamental, 3x fundamental frequency and 4x fundamental frequency respectively. Sometimes, the electrical signals potentially (namely, may) include harmonic components at 1/2, or 1/3, or 1/4 or 1/5 x fundamental frequencies or 2/3 or 4/5 or some strange number like 3.27x fundamental frequency; or more often such multiples of shaft speed, rather than multiples of line frequency. The shaft speed is typically variable, for example, in the range of 95% to 99% of line frequency, in a range of 95% to 99% of half of line frequency for a four-pole motor or a four-pole generator, or in a range of 95% to 99% of one third of line frequency for a 6-pole motor or a 6-pole generator, etc.

According to yet another embodiment, the data processing arrangement of the at least one monitoring unit is operable to access (namely, accesses when in operation) the one or more stored models of operation of the at least one electrical device, and to compare the real-time model with the one or more stored models to generate information indicative of an operating condition of the at least one electrical device. According to yet another embodiment, the data processing arrangement is operable to generate the real-time model of the at least one electrical device based on the analysis data.

In an embodiment, the data server arrangement is configured (namely, is arranged to) to provide a user interface for user entry of user defined parameters for generating a range of multivariate cells in a database of the data server arrangement and the data server arrangement is configured to update the sensed data of the at least one electrical device in their respective multivariate cells. In an embodiment, the data server arrangement is configured to generate a smaller version of multivariate cells that represents the sensed data within the multivariate cells for a limited number of readings of the voltage and the current and to interpolate or extrapolate from these readings to provide the expected characteristics for any combination of load and speed. In an embodiment, the data server arrangement is configured to update pre-existing analysis data in their respective multivariate cells with the analysis data to generate aggregated analysis data. The one or more models (e.g. the real-time model and/or the one or more stored model) may be stored in the multivariate cells. The multivariate cells may also store the temporally-changing Fourier spectrum of at least one of the current or the voltage, or both that is supplied to and/or from the at least one electrical device. The one or more stored models optionally include the values of the supply of voltage or the supply of current, or both, that are supplied to and/or from the at least one electrical device during previous measurements and its corresponding temporally-changing Fourier spectrum and alerts generated for the at least one electrical device.

According to yet another embodiment, the at least one monitoring unit is included as an integral component of the at least one electrical device. For example, the household appliance such as a refrigerator, a washing machine, a vacuum cleaner etc., optionally includes the at least one monitoring unit as an integral component for monitoring purposes. Moreover, when the at least one electrical device is a generator, for example, in a remote wind turbine, tidal turbine or wave energy turbine, the at least one electrical device optionally includes the at least one monitoring unit as an integral component for monitoring purposes.

According to yet another embodiment, the data communication network is implemented via use of Internet-of-Things (IoT). According to yet another embodiment, the data communication network is implemented via use of Internet-of-Things (IoT) implemented, for example at least in part or completely, in a wireless manner and/or via a peer-to-peer communication network. The wireless communication is optionally implemented as a Bluetooth^{®}, wireless fidelity (Wi-Fi), a ZigBee^{®} facility, a LTE facility, an infrared communication facility, etc. The peer-to-peer communication network is optionally an *ad hoc* connection through a Universal Serial Bus (USB), Bluetooth^{®} or Ethernet^{®}, etc.

According to yet another embodiment, the data processing arrangement is configured (namely, is arranged when in operation) to compute parameter differences between the real-time model and the one or more stored models, and to generate a predictive model describing the parameter difference between the real-time model and the one or more stored models to generate the information indicative of an operating condition of the at least one electrical device. According to yet another embodiment, the data processing arrangement generates from the predictive model one or more alerts relating to:
(a) energy utilization trends of the at least one electrical device;
(b) Carbon Dioxide (equivalent) generation being caused by the at least one electrical device; and
(c) maintenance, replacement or repair of the at least one electrical device.

According to yet another embodiment, the at least one electrical device includes at least one of: a synchronous 1-phase electrical motor, a synchronous multi-phase electrical motor, a synchronous 3-phase electrical motor, an asynchronous 1-phase motor, an asynchronous 3-phase motor, a generator, an alternator, a switched reluctance motor, a switched stepper motor, a D.C. electrical motor, a compressor, a pump, an air conditioner, a ventilator, a refrigerator, a washing machine, a television, a vacuum cleaner or a heater. The at least one electrical device optionally includes static devices, for example ovens, solar panels, battery energy storage, supercapacitor energy storage, ultracapacitor energy storage, and similar. However, it will be appreciated that embodiments of the present disclosure can be used to monitor other types of electrical devices, for example industrial microwave ovens (e.g. to detect electrode erosion or vacuum degradation), resistive heating element ovens (e.g. to detect heating element progressive oxidation or heating element micro-cracking), solar cell generating performance (e.g. condensation, element ageing, solar cell cracking).

According to yet another embodiment, the user interface is configured (namely, is arranged in operation) for obtaining user entry of machine parameters describing the at least one electrical device, wherein the machine parameters include at least one of: generic nominal operating voltage, generic nominal operating current, generic nominal supply frequency, generic nominal rotational speed, number of vanes on an impeller of the at least one electrical device, bearing type codes of the at least one electrical device or belt drive dimensions of the at least one electrical device.

According to yet another embodiment, the user interface is configured (namely, is arranged when in operation) for user entry of machine parameters describing analysis type to be executed by the data processing arrangement, wherein the analysis type allows user-setting of temporal resolution and a sensing data sample length. According to yet another embodiment, the user interface allows user setting of voltage and/or current readings from the at least one electrical device at a sample rate of at least 2 MegaHertz (2 MHz) to 10 MegaHertz (10 MHz). Optionally, a sampling rate greater than 10 MHz is employed. Yet more optionally, a sampling rate in a range of 2.5 kHz to 125 MHz is employed.

According to yet another embodiment, the user interface allows user-selection for implementing D-Q phase and A-B phase transformation, computed in the data processing arrangement, of the sensed data, wherein the D-Q phase transformation transfers three-phase stator and rotor quantities into a single rotating reference frame to eliminate effect of time-varying inductances, wherein the A-B phase transformation refers to a mathematical transformation that is implemented to simplify the analysis of three-phase stator and rotor.

According to yet another embodiment, the data processing arrangement is configured to create a linear model of one or more relationships between voltage and current signals obtained from the at least one electrical device.

According to yet another embodiment, the data processing arrangement is operable to:
(i) generate a linear model describing the at least one electrical device;
(ii) use the linear model to create a model of predicted current of the at least one electrical device from measured voltages obtained from the at least one electrical device;
(iii) compare the model of predicted current with a measured current of the at least one electrical device to create a residual current data;
(iv) perform Fast Fourier Transform (FFT) on the residual current data to create the temporally-changing Fourier spectrum;
(v) identify at least one local maximum on the temporally-changing Fourier spectrum by analyzing the temporally-changing Fourier spectrum that are plotted based on the sensed data using a crawling technique, wherein an entirety of the temporally-changing Fourier spectrum is divided into local maxima joined to one another at local minima to identify at least one local maximum corresponding to a phenomenon on the temporally-changing Fourier spectrum, wherein the crawling technique identifies the at least one local maximum on the temporally-changing Fourier spectrum by determining a value that increases towards the at least one local maximum or a value that decreases from the at least one local maximum;
(vi) calculate locations on the temporally-changing Fourier spectrum where the same phenomenon appears to create a family of possible local maxima;
(vii) identify a significant local maximum from the family of possible local maxima corresponding to the phenomenon and generate the analysis data from a magnitude of the significant local maximum, wherein the significant local maximum is identified in terms of an absolute value or number of standard deviations from a mean value: and
(viii) label the significant local maximum with the phenomenon description in the user interface for presenting to the user.

In an embodiment, an identification of a family of local maxima is beneficial in providing more reliable predictions and hence avoiding false alarms (namely, "false positives") that can be costly and/or time consuming to address.

In an embodiment, the data processing arrangement is operable to use the linear model to create a model of predicted voltage of the at least one electrical device from measured current obtained from the at least one electrical device and compare the model of predicted voltage with a measured voltage of the at least one electrical device to create the residual voltage data. The data processing arrangement optionally performs Fast Fourier Transform (FFT) on the residual voltage data to create the temporally-changing Fourier spectrum.

In an embodiment, the data processing arrangement is configured (namely, is arranged in operation) to compute an analysis of at least one of a numerical algorithm for Sub-Space State-Space System Identification (N4SID), a Multivariable Output Error State Space (MOESP) algorithm, a Past Outputs Multivariable Output Error State-Space (PO-MOESP) algorithm or Canonical Variate Analysis (CVA) to generate the real-time model based on the sensed data. The subspace identification methods (SIMs), such as past outputs multivariable output-error state space (PO-MOESP), numerical algorithms for subspace state-space system identification (N4SID), and Canonical Variate Analysis, generate a real-time model (e.g. a state-space model) based on the sensed data. Multivariable Output Error State Space (MOESP) and Numerical algorithms for Subspace State Space System Identification (N4SID) algorithms are two known subspace identification techniques. The numerical algorithm for Subspace and state-space identification is typically faster, when implemented correctly, than prediction error methods, because the numerical algorithm for Subspace and state-space identification are basically non-iterative, exploiting basic algorithms from numerical linear algebra, such as LQ-decomposition (transpose of the QR decomposition) and the singular value decomposition to generate the real-time model based on the sensed data. In an embodiment, the data processing arrangement is configured to compute an analysis of at least one of the numerical algorithm for Sub-Space State-Space System Identification (N4SID), the Multivariable Output Error State Space (MOESP) algorithm, the Past Outputs Multivariable Output Error State-Space (PO-MOESP) algorithm or the Canonical Variate Analysis (CVA) to generate the stored model or linear model based on the voltage and the current signals obtained from the electrical device

In an embodiment, the data processing arrangement identifies the at least one local maximum corresponding to a phenomenon on the temporally-changing Fourier spectrum by applying well established rules (e.g. 1X rotational speed is an indicator of unbalance or eccentricity and 2X supply frequency is an indicator of stator winding problems). In an embodiment, a location on the temporally-changing Fourier spectrum at which the at least one local maximum appears is *m*fₗ +/- *n*fₚ, where fₗ is a line frequency and fₚ is frequency of the phenomenon of interest and m and n are integers. In an embodiment, any particular phenomenon provides local maxima on either side of line frequency and/or on harmonics of the line frequency. It will be appreciated that the data processing arrangement is operable to identify potential faults depending upon whether *m* and *n* are indicative of odd or even harmonics.

In an embodiment, the data processing arrangement employs a change-point technique (e.g. a Cumulative Sum (CUSUM) algorithm) to identify changes in the parameters of the at least one electrical device. The voltage and current signals are potentially noisy from many reasons, for example due to electrical switching noise, namely a form of signal distortion. However, it will be appreciated that unexpected magnetic saturation can also potentially give rise to signal distortion, that the data processing arrangement is capable of detecting. The change-point technique is a technique that is typically used for monitoring change detection. The change-point technique is capable of helping the electrical condition monitoring system to detect 1% change in a mean of the voltage and current signal which is varying by +/-50% or so.

The data processing arrangement optionally generates the trend graph (i.e. the analysis data) by employing a curve fitting process on the trend graph which is derived from the temporally-changing Fourier spectrum. The curve fitting process refers to a process of constructing a curve, or mathematical function that has the best fit to a series of data points, optionally subject to constraints. In an embodiment, the trend graph is extrapolated using a curve fitting technique (e.g. linear, parabolic or exponential) for future purpose.

The data processing arrangement optionally determines the change-point technique and the curve fitting process to be employed based on normalized sets of data associated with different loads and different speeds. The process of determining the change-point technique and the curve fitting process is very complex; moreover, the model parameters and the various parameters derived from the model are also very sensitive to the load. For example, if the load of the at least one electrical device is changed, the current supplied to and/or from the at least one electrical device can be changed without changing the supply of voltage. Thus, parameter values of the linear models are sensitive to changes in the load and speed as aforementioned. As the parameter values of the linear models are used to identify the problems inside the at least one electrical device (e.g. a refrigerator, a vacuum cleaner, a washing machine, a pump, an electrical motor, a fan or a generator) or in the electrical signals, the data processing arrangement is designed to avoid generating false alerts if the change is only due to the load or speed of the at least one electrical device. The data processing arrangement optionally compares the parameter values of the linear model or stored model with parameter values of a real-time model to determine the expected parameter values at a particular load and speed. The data processing arrangement compares the parameter values by creating a set of individual cells and each cell corresponds to a particular range of load and speed (e.g. the frequency is 40 Hz to 45 Hz and the supply of current is in a range of 100 Amperes to 110 Amperes). During a baseline process that is generally carried out after (i) initial installation and (ii) commissioning of the at least one electrical device, or a combination of both (i) and (ii), a set of sensed data is taken for each time and their results are updated in their corresponding cell. In an embodiment, the electrical condition monitoring system determines characteristics of a relationship between the parameter values and the load and speed of the at least one electrical device. The electrical condition monitoring system uses the characteristics of the relationship to assess an expected parameter value for a measured load and speed of the at least one electrical device, without having to have previously populated data in a particular cell.

The present disclosure also provides a method for (of) using an electrical condition monitoring system, characterized in that the electrical condition monitoring system includes a data server arrangement that is connectable via a data communication network arrangement to at least one monitoring unit that is spatially local to a corresponding at least one electrical device, and that is configured to monitor the at least one electrical device when the at least one electrical device is in operation, wherein the method includes:
(i) arranging the at least one monitoring unit to include a sensing arrangement that temporally senses electrical signals associated with the at least one electrical device and generates corresponding sensed data by processing the sensed electrical signals associated with the at least one electrical device, wherein the sensed data includes information associated with at least one of a supply of voltage or a supply of current to and/or from the at least one electrical device;
(ii) arranging the at least one monitoring unit to include a data processing arrangement including a data processor that is configured to process the sensed data to generate a corresponding temporally-changing Fourier spectrum including signal harmonic components for at least one of the current or the voltage that is supplied to and/or from the at least one electrical device (optionally, or for a calculated residual current or residual voltage) and to process temporal changes in magnitudes and frequencies of the signal harmonic components to generate analysis data representative of operation of the at least one electrical device; and
(iii) configuring the at least one monitoring unit to communicate the analysis data to the data server arrangement to perform at least one of:
   (a) aggregating the analysis data received from the at least one monitoring unit to obtain aggregated analysis data;
   (b) generating aggregated performance results in respect of the at least one electrical device based on the aggregated analysis data;
   (c) providing control signals to at least one monitoring unit to monitor operation of the at least one electrical device based on the aggregated performance results of the at least one electrical device;
   (d) generating alerts relating to the at least one electrical device when the aggregated performance results of the at least one electrical device exceeds a threshold level, wherein the alerts represent at least one of: maintenance required for the at least one electrical device, replacement required for different parts of the at least one electrical device or potential causes for failure of the at least one electrical device; and
   (e) generating a condition assessment of the at least one electrical device, wherein a condition of the at least one electrical device is assessed based on comparison between a real-time model of the at least one electrical device generated based on the analysis data with one or more stored models of the at least one electrical device (for example, one or more stored models of a plurality of electrical devices). Such a condition assessment includes, for example, a state of insulation employed in the at least one electrical device, wherein the state of insulation includes for example variations in a *"tan-delta"* phase angle of harmonic components of alternating current relative to applied voltage indicative of a change of the insulation from a lossless capacitive dielectric to a lossy at least partially resistive dielectric.

The advantages of the present method are thus identical to those disclosed above in connection with the present system and the embodiments listed above in connection with the present system apply *mutatis mutandis* to the present method.

The present disclosure also provides a computer program product comprising a non-transitory computer-readable storage medium having computer-readable instructions stored thereon, the computer-readable instructions being executable by a computerized device comprising processing hardware to execute the aforementioned method.

The advantages of the present computer program product are thus identical to those disclosed above in connection with the present system and the embodiments listed above in connection with the present system apply *mutatis mutandis* to the computer program product.

Embodiments of the present disclosure thus monitor the operating conditions of the at least one electrical device (e.g. a refrigerator, a vacuum cleaner, a washing machine, a pump, an electrical motor, a fan, a generator, a dynamo, etc.) more accurately than the existing monitoring systems, over a period of time. Embodiments of the present disclosure may help to avoid performing unnecessary maintenance works on the at least one electrical device; such avoidance is especially valuable when the electrical device is at a remote location that is costly and/or difficult to access. Embodiments of the present disclosure thus manage current and voltage measurements having distortion and infer the sensed data from measured voltage and current signals, for effectively monitoring the operating condition of the at least one electrical device. Embodiments of the present disclosure may be easily connected with the electrical device and may not require any configuration changes in the at least one electrical device to deploy it. Embodiments of the present disclosure help to save the maintenance cost of the at least one electrical device to a larger extent by adopting a condition-based maintenance strategy for the maintenance of the at least one electrical device.

### DETAILED DESCRIPTION OF THE DRAWINGS

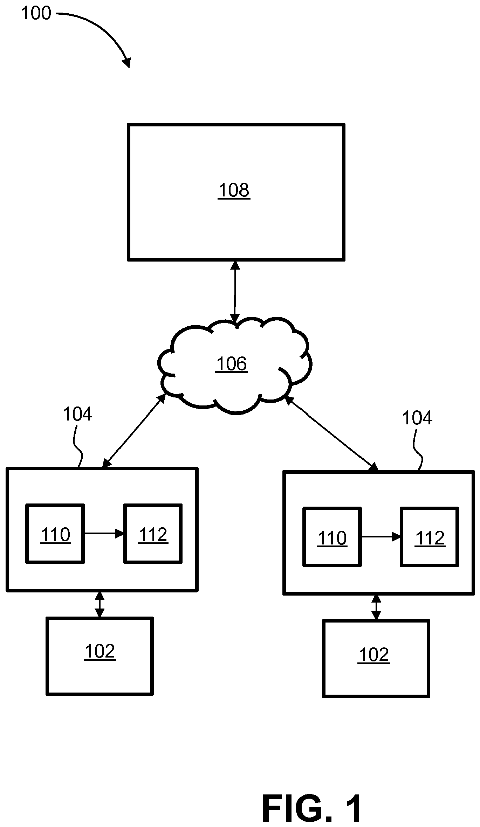

FIG. 1 is a schematic illustration of an electrical condition monitoring system **100** in accordance with an embodiment of the present disclosure. The electrical condition monitoring system **100** includes an at least one electrical device **102,** at least one monitoring unit **104** and a data server arrangement **108.** The at least one monitoring unit **104** is connected with the data server arrangement **108** through a data communication network arrangement **106.** The at least one monitoring unit **104** includes a sensing arrangement **110** and a data processing arrangement **112.** The data processing arrangement **112** includes a data processor. These parts have functions as described above.

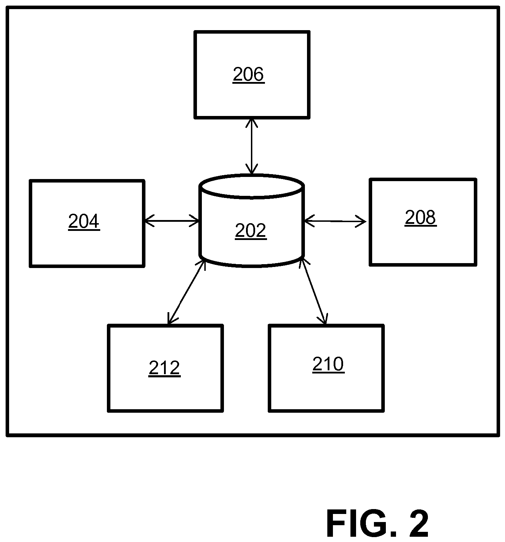

FIG. 2 is a functional block diagram of a data server arrangement in accordance with an embodiment of the present disclosure. The functional block diagram of the data server arrangement comprises a database **202,** a data aggregation module **204,** a performance results generation module **206,** control signal generation module **208,** an alert generation module **210** and a condition assessment module **212.** The database **202** includes a range of multivariate cells; these modules **204, 206, 208, 210, 212** can be implemented in hardware (e.g. custom-designed logic circuits, FPGA, ASIC, etc.) or in software executable upon computing hardware, or a combination thereof. The multivariate cells store analysis data of at least one electrical device. The multivariate cells store a temporally-changing Fourier spectrum that is generated based on sensed data of the at least one electrical device and one or more stored models associated with the at least one electrical device. The data aggregation module **204** aggregates analysis data received from at least one monitoring unit to obtain aggregated analysis data. The performance results generation module **206** generates aggregated performance results in respect of the at least one electrical device based on the aggregated analysis data. The control signal generation module **208** provides control signals to the at least one monitoring unit to monitor operation of the at least one electrical device based on the aggregated performance results of the at least one electrical device. The alert generation module **210** generates alerts relating to the at least one electrical device when the aggregated performance results of the at least one electrical device exceeds a threshold level. The threshold level may be a level that indicates an optimal operating condition of the at least one electrical device. The alerts represent at least one of maintenance required for the at least one electrical device, replacement required for different parts of the at least one electrical device or potential causes for failure of the at least one electrical device, for example a potential risk of breakdown of insulation of the at least one electrical device (as monitoring in real-time or periodically from the at least one device a potential breakdown in insulation of the at least one electrical device in a manner as described in the foregoing utilizing *"tan-delta"* measurements.
The condition assessment module **212** provides a condition assessment of the at least one electrical device. The condition of the at least one electrical device is assessed based on comparison between a real-time model of the at least one electrical device generated based on the analysis data with the one or more stored models of the at least one electrical device (for example one or more stored models of a plurality of electrical devices).

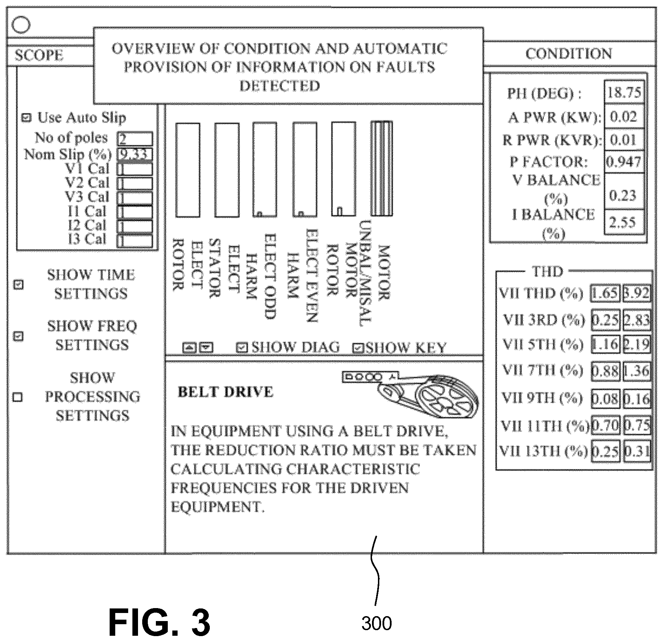

FIG. 3 is an exemplary view of a graphical user interface (GUI) **300** of an electrical condition monitoring system in accordance with an embodiment of the present disclosure. The graphical user interface **300** depicts bar graphs that show to a given user an operating condition of an electrical device and information associated with faults detected in the electrical device (e.g. a belt drive). The bar graphs show operating conditions of different parts of the electrical device such as an electrical rotor, an electrical stator, an electrical odd harmonic, an electrical even harmonic, a motor rotor, a generator rotor, a dynamo rotor, etc. Each bar graph may represent a fault on different parts of the electrical device.

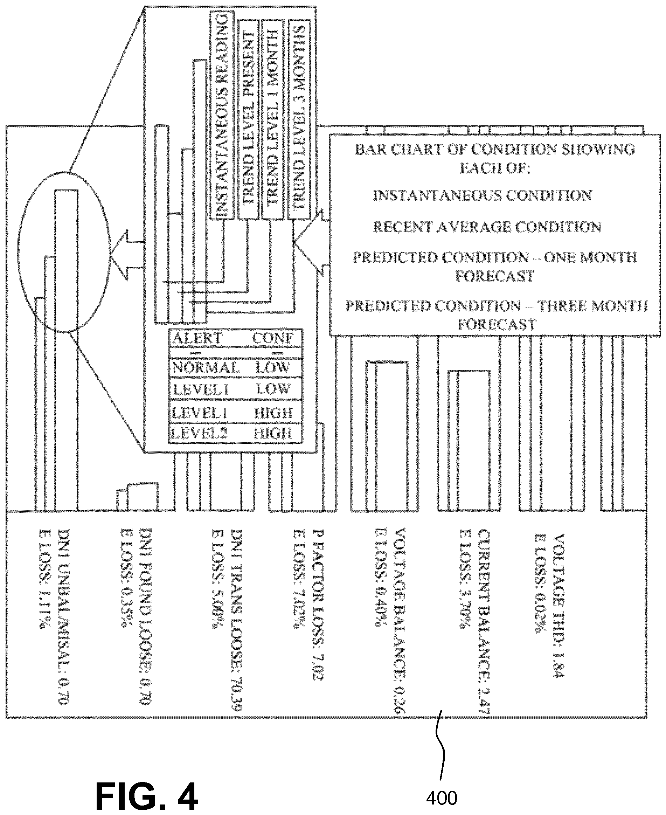

FIG. 4 is an exemplary view of a graphical user interface (GUI) **400** of an electrical condition monitoring system that depicts operating conditions of an electrical device in accordance with an embodiment of the present disclosure. The graphical user interface **400** depicts bar graphs that show instantaneous operating condition of the electrical device based on, for example, current readings, voltage readings, recent average operating condition of the electrical device, predicted operating condition of the electrical device for one month and three-month forecast.

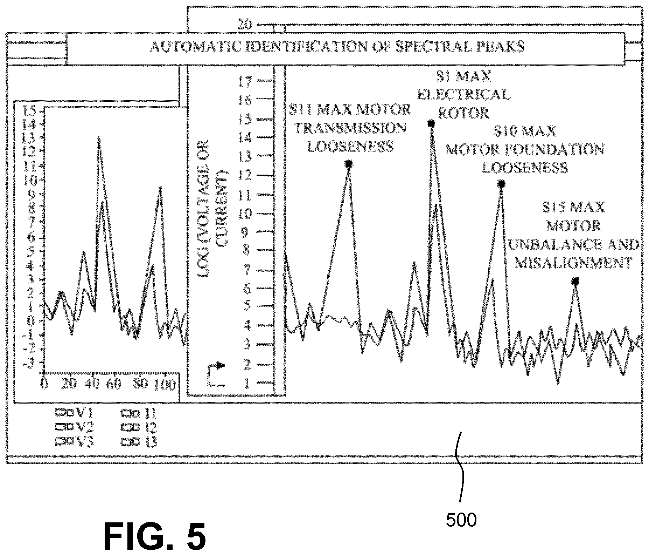

FIG. 5 is an exemplary (sketch) view of a graphical user interface (GUI) **500** of an electrical condition monitoring system that depicts an identification of peaks (e.g. local maxima) in a temporally-changing Fourier spectrum in accordance with an embodiment of the present disclosure. The graphical user interface **500** depicts identification of various peaks (e.g. local maxima) corresponding to different phenomenon on the temporally-changing Fourier spectrum that is generated based on sensed data of an electrical device. For example, a peak S1 depicts an operating condition of an electrical rotor associated with the electrical device, a peak S10 depicts motor foundation looseness in the electrical device, a peak S11 depicts motor transmission looseness in the electrical device and a peak S15 depicts driven unbalance and misalignment in the electrical device.

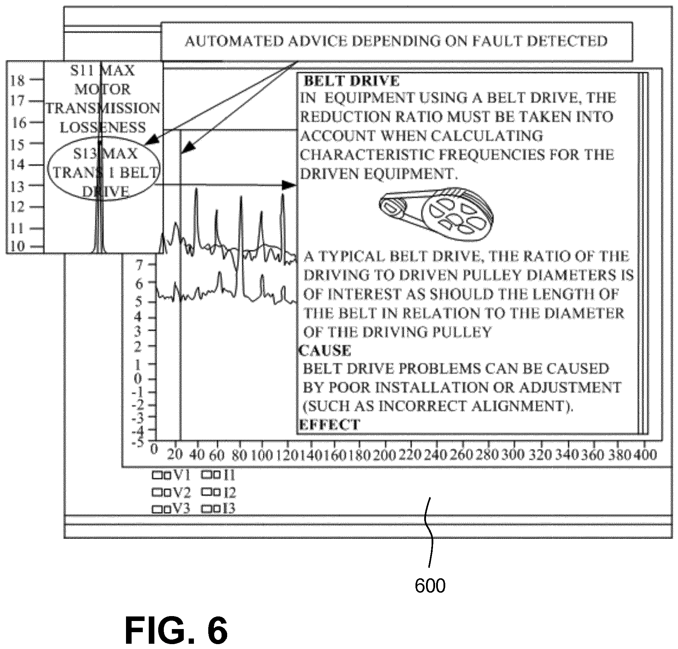

FIG. 6 is an exemplary view of a graphical user interface (GUI) **600** of an electrical condition monitoring system that depicts suggestions to a fault detected in a belt drive of an electrical device in accordance with an embodiment of the present disclosure. The graphical user interface **600** shows a family of possible peaks (e.g. local maxima) corresponding to a phenomenon (e.g. fault / problem). The graphical user interface **600** provides a description, a cause and an effect of a fault detected in the belt drive. For example, the description provides information associated with faults / problems detected in the belt drive. The description indicates that the problem / fault detected in the belt drive is due to poor installation or an adjustment (e.g. incorrect alignment), excessive loads or incorrect tensioning in the belt drive.

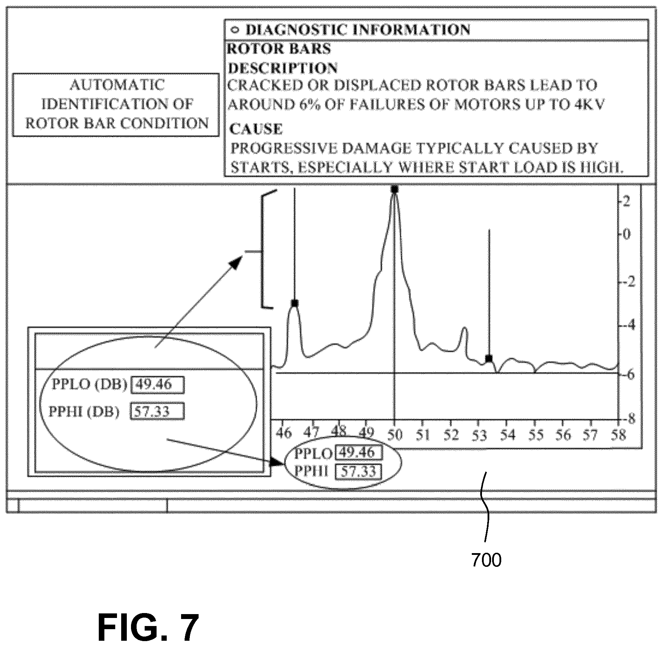

FIG. 7 is an exemplary view of a graphical user interface (GUI) **700** of an electrical condition monitoring system that depicts automatic identification an operating condition of a rotor bar in accordance with an embodiment of the present disclosure. The graphical user interface **700** shows a peak (e.g. local maximum) that indicates an operating condition of the rotor bar along with a description pertaining thereto. The description indicates that the rotor bar is cracked or displaced which leads to around 6% of failures of motors, *mutatis mutandis* generators, up to a 4 kiloVolt (kV) specification and around 13% of failures of the motors, *mutatis mutandis* generators, above a 4 kiloVolt (kV) specification. The graphical user interface **700** also depicts that the crack or displacement of rotor bar may be caused by starts, specifically when a given start load is excessively high and caused by high load variations and time-related deterioration.

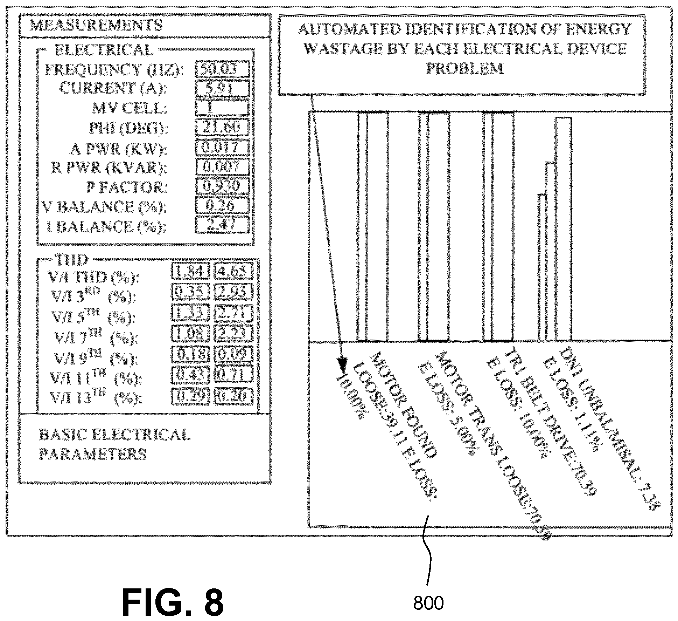

FIG. 8 is an exemplary view of a graphical user interface **800** of an electrical condition monitoring system that depicts automatic identification of energy wastage in an electrical device in accordance with an embodiment of the present disclosure. The graphical user interface **800** shows a family of peaks (e.g. local maxima) that indicate automatic identification of the energy wastages occurred due to a problem / fault in the electrical device.

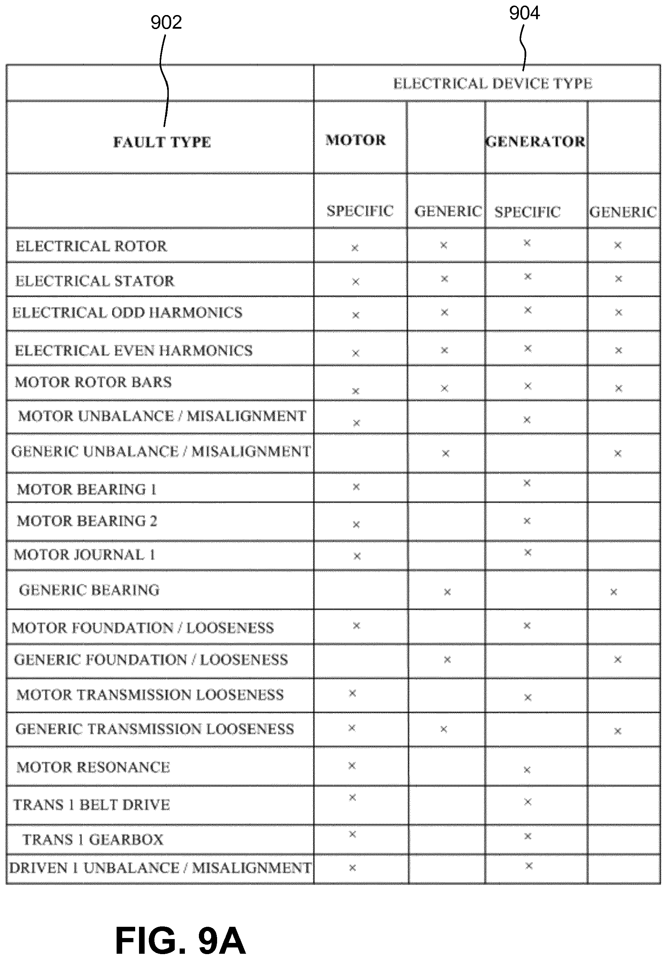

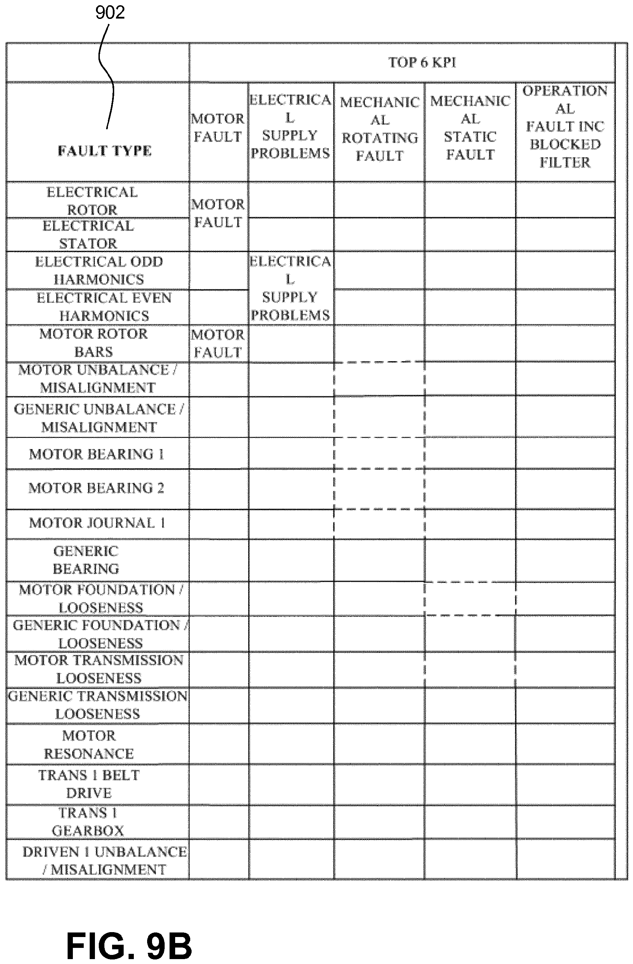

FIGS. 9A and 9B are exemplary tabular views that depict detection of faults in at least one electrical device using an electrical condition monitoring system in accordance with an embodiment of the present disclosure. The tabular views show a fault type field **902** and an electrical device type field **904.** The fault type field **902** includes a type of faults detected in different parts (e.g. an electrical rotor, an electrical stator, motor rotor bars, a motor bearing 1, a motor bearing 2, generator rotor bars, a generator bearing 1, a generator bearing 2, etc.) of the at least one electrical device. The electrical device type field **904** includes a different type of electrical devices (e.g. a motor and a generator). The tabular views depict types (e.g. generic faults and specific faults) of faults detected in the different electrical devices. Generic faults are detected when there is no special information entered about the at least one electrical device apart from its nominal voltage, nominal current and nominal rotational speed. Specific faults are detected when appropriate information (typically, rotating element bearing type code numbers, a ratio of transmissions and pulley diameters and separation distance for belt drives) is entered into the electrical condition monitoring system.

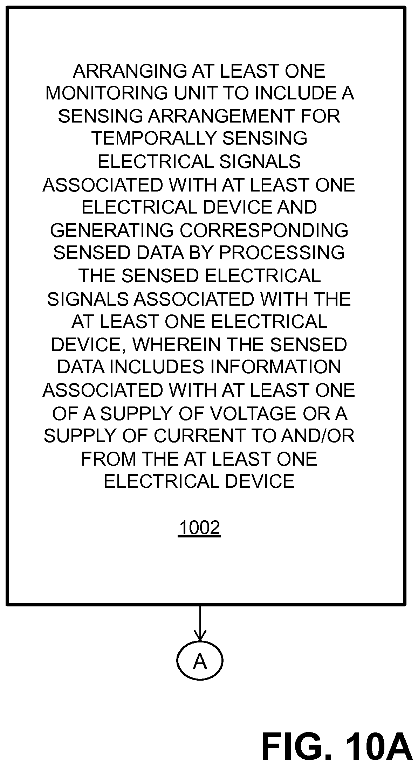

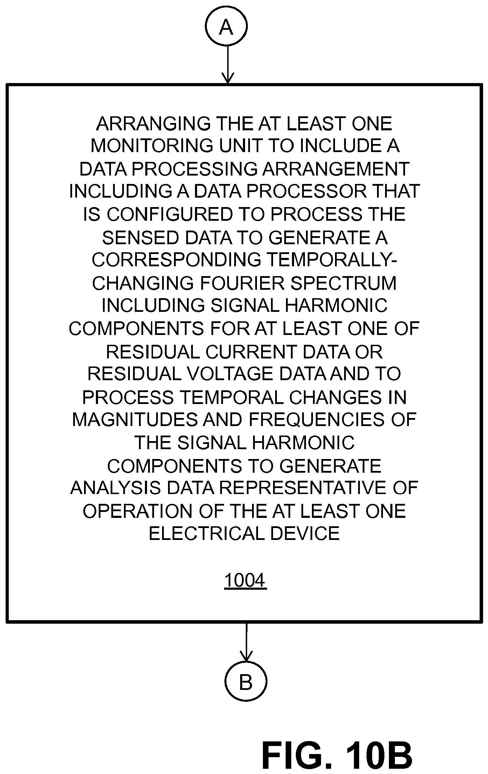

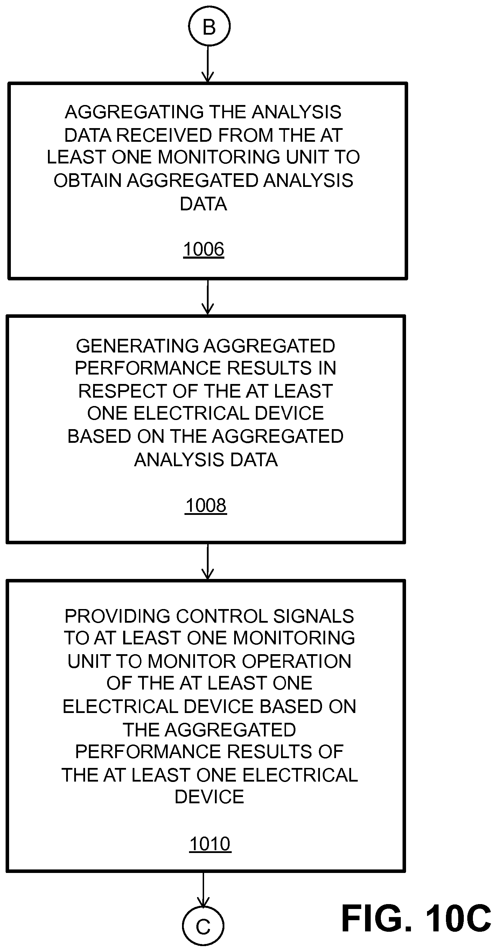

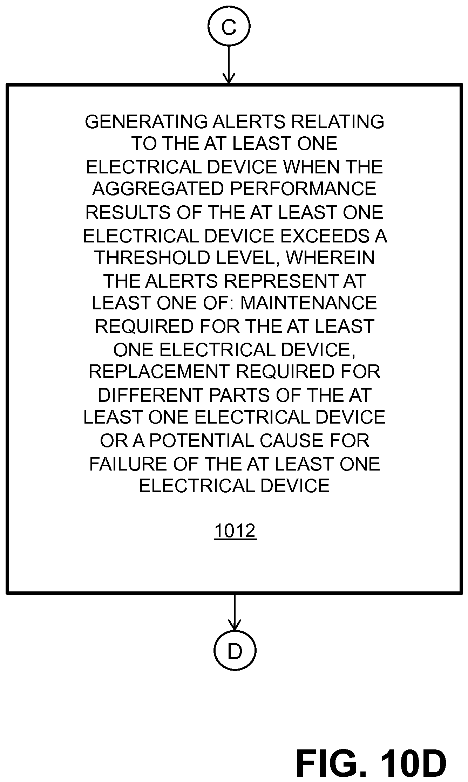

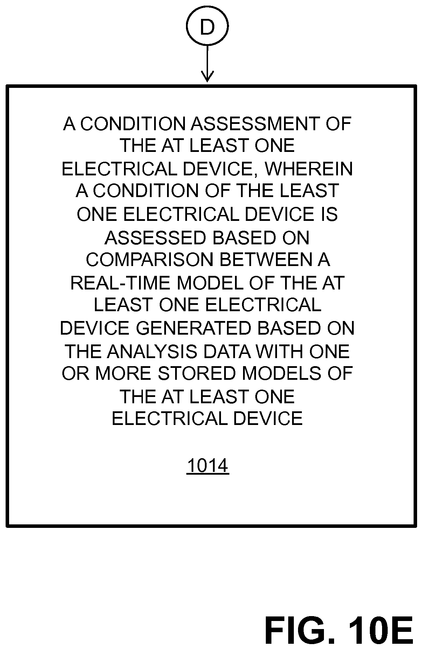

FIGS. 10A to 10E are flow diagrams illustrating steps of a method **1000** in accordance with an embodiment of the present disclosure. At a step **1002,** at least one monitoring unit is arranged to include a sensing arrangement for temporally sensing electrical signals associated with at least one electrical device and generating corresponding sensed data by processing the sensed electrical signals associated with the at least one electrical device. The sensed data includes information associated with at least one of a supply of voltage or a supply of current to and/or from the at least one electrical device. At a step **1004,** the at least one monitoring unit is arranged to include a data processing arrangement including a data processor that is configured to process the sensed data to generate a corresponding temporally-changing Fourier spectrum including signal harmonic components for at least one of the current or the voltage that is supplied to and/or from the at least one electrical device and to process temporal changes in magnitudes and frequencies of the signal harmonic components to generate analysis data representative of operation of the at least one electrical device. At a step **1006,** the analysis data received from the at least one monitoring unit is aggregated to obtain aggregated analysis data. At a step **1008,** aggregated performance results is generated in respect of the at least one electrical device based on the aggregated analysis data. At step a **1010,** control signals are provided to the at least one monitoring unit to monitor operation of the at least one electrical device based on the aggregated performance results of the at least one electrical device. At a step **1012,** alerts relating to the at least one electrical device is generated when the aggregated performance results of the at least one electrical device exceeds a threshold level. The alerts represent at least one of maintenance required for the at least one electrical device, replacement required for different parts of the at least one electrical device or potential causes for failure of the at least one electrical device. At a step **1014,** a condition assessment of the at least one electrical device is provided. A condition of the at least one electrical device is assessed based on comparison between a real-time model of the at least one electrical device generated based on the analysis data with one or more stored models of the at least one electrical device.

Embodiments of the present disclosure concern a type of technology that is capable of reducing Carbon Dioxide (CO₂) emissions, as a result of improving operation of electrical devices, for example electrical machines, at higher efficiency and avoiding unnecessary maintenance.

Although sensing and monitoring of a single electrical device is described in the foregoing, it will be appreciated that the electrical condition monitoring system **100** is capable of being arranged, namely configured, so that the sensing arrangement **106** senses currents and/or voltages of connection points that are coupled to a plurality of electrical devices; for example, the sensing arrangement (for example, implemented as voltage probes and/or clamp-on current sensors) **106** is coupled at a main electrical junction box that feeds, or receives power from, an array of electrical devices. In such an embodiment, the filtering module **204,** the spectrum analysis module **206,** the real-time model generation module **208** and the model comparison module **210** are arranged to employ one or more models corresponding to an aggregate of a plurality of electrical devices. However, the electrical devices are potentially operating in mutually different states (for example, some motors or generators being stationary whereas other of the motors or generators being operable at mutually different power magnitudes or rotation rates) that makes the system **100** more complex in its operation. However, such a manner of operation is potentially cost-effective, because installing the sensor arrangement **106** may be a costly personnel-intensive (namely, labor-intensive) activity, for example where remote telemetry is also required.

In other words, the system **100** is able to connect to multiple motors, multiple generators, or a combination of one or more motors and one or more generators, and diagnose faults or other phenomena occurring in any one of the motors and/or generators. The sensing arrangement **106,** for example, is conveniently coupled at a switchboard associated with the multiple motors, multiple generators, or combination thereof.

Employing the system **100** to monitor and diagnose concurrently multiple electrical devices is more complex, because signals generated from the sensor arrangement **106** in respect of the multiple electrical devices is effectively aggregated, namely mutually merged into a single signal. The system **100** is able to identify individual parameters in a meaningful way from such an aggregate signal. Where the different motors, alternatively different generators, or both, are driving different types of equipment, the profile of each type of equipment is different, and at least some of the fault frequencies pertaining to the equipment will be different. By building up a profile of each motor in turn, *mutatis mutandis* each generator in turn, the system **100** is able to build an expected profile in total of all the motors running at that time, *mutatis mutandis* generators running at that time, and then compare it with the actual overall profile (namely spectrum). Where the motors, *mutatis mutandis* the generators, are driving, or being driven by, identical types of equipment, the fault frequencies will be identical for each item of equipment. The system **100** is able to identify a nature of the fault, but not which motor, *mutatis mutandis* generator, is responsible for the fault. Optionally, narrowing down a given motor, *mutatis mutandis* a given generator, with the fault is achieved in the system **100** by correlating a presence or absence at a given time of the fault signal with which motors, *mutatis mutandis* which generators, are or are not running at that given time.

The system **100** is capable of being operated to determine and record a set of baselines corresponding to a range of combinations of operational parameters that pertain to one or more motors, and/or one or more generators. Such operation parameters concern, for example, a relationship between load and rotation speed of a given electrical device, for example manifest as a relationship between current and rotational frequency of the electrical device; in the system **100,** subsequent monitoring and diagnostics are implemented by comparing subsequently monitored measurements or derived data against such baselines.

As aforementioned, the real-time model generation module **208** generates a real-time model of the electrical device based on the analysis data. This real-time model corresponding to baseline information conveniently stored in multivariate cells within computing hardware, that are filled by actual measurements, in other words sensor data, during a baselining process when initially characterizing a given electrical device, for example an electrical motor or an electrical generator. However, in a case where not every relevant combination of operational parameters has been encountered during such a baselining process, data appropriate to unencountered combinations of operational parameters are optionally created by a suitable mathematical method; this mathematical method is optionally implemented as follows, for example:
(i) there is employed a process of interpolation or extrapolation from the baseline data in nearby (for example, neighboring) multivariate cells, to create a matrix of extrapolated multivariate cells across a range of operational parameters of interest. Optionally, this matrix of extrapolated multivariate cells is updated, using an updating process, with actual data subsequently collected after the initial baselining process has been completed; or
(ii) there is employed a process of creating a mathematical relationship between the monitored measurements or derived data and the operational parameters in a form (conceptually) of an equivalent 3-dimensional or multidimensional *"surface".* This relationship is then used to calculate the values of monitored measurements and/or derived data that would be expected for any combination of values of aforesaid operational parameters.

It will be appreciated that by interpretation of *"model parameters",* these may be parameters of the mathematical models used in the system **100** or may be parameters that describe physical quantities of a given motor or generator, such as rotor resistance, rotor reactance, stator resistance, stator reactance.

It will further be appreciated that the electrical condition monitoring system **100,** namely operating as a form of diagnostic system, identifies distortions in a sensed current signal that has a current waveform that have not been caused by distortions of a corresponding voltage signal that has a voltage waveform, to create a residual current signal, which is then used for executing further analysis. Temporal changes in a given electrical device, for example a load applied to a motor or output from a generator, causes a change in the overall current drawn or supplied by the electrical device, without causing significant change in the voltage signal, so such load or output changes result in apparent changes in the residual current. These apparent changes, in earlier known diagnostic system, potentially lead to spurious identification of faults. Embodiments of the present disclosure by capturing a range of *"typical"* readings and their associated spectra and model parameters, and storing associated data representative of the spectra and model parameters in individual cells of a matrix defining a relationship between load and rotation speed (i.e. rotation frequency), or output and rotation speed (i.e. rotation frequency). Optionally, embodiments of the present disclosure capture multiple sets of data for each combination of load and speed for a motor, *mutatis mutandis* output and speed for a generator, and average them or aggregate them as a part of a baselining process employed within the electrical condition monitoring system **100.** The diagnosis of problems is then based in the system **100** on a comparison of a reading at any particular time against the baseline established for that combination of load and speed for the given motor, *mutatis mutandis* output and speed for the given generator. The greater the number of cells employed in the aforesaid matrix, the closer the comparison between the monitoring and baseline readings, and therefore the more valid the diagnosis provided by the system **100** when in operation. However, the larger the number of cells in the matrix, the lower the likelihood of all cells being encountered during the baselining process, and hence the need to fill in these empty cells in some way, for example by way of using extrapolation or interpolation as aforementioned.

As aforementioned, the mathematical methods employed within the system **100** for identifying distortions on a current waveform that have not been caused by distortions on a corresponding voltage waveform involves creating mathematical models of the relationship between voltage and current measurements. Moreover, as aforementioned, these models utilize a plurality of model parameters, whose values potentially temporally change each time a measurement is taken using the system **100.** By relating such model parameters to a physical model of an electric motor, *mutatis mutandis* an electrical generator, the values of the physical parameters, such as rotor resistance, stator resistance and so forth, may be assessed, in particular by identifying changes in the model parameters that may be related to underlying physical changes.

Detection of such changes, for example, allows detection to be made of early stages of electrical insulation breakdown, for example rotor and/or stator electrical winding breakdown; such detection involves a measurement of capacitance and resistance of the electrical insulation, For example, such an early detection is achievable by measuring the capacitance and resistance of the insulation at a range of frequencies, by analyzing a relationship between voltage and current at a range of different frequency components by using harmonics already present in the voltage and current signals, for example isolated by performing aforesaid Fourier analysis of measured current and voltage signal captured by the system **100;** optionally, such measurements are made in conjunction with employing aforementioned models. In contradistinction, traditional *"simple"* methods of assessing integrity of insulation involves measuring a resistance from a conductor abutting the insulation to Earth. This resistance is normally very high, namely in an order of MegaOhms. If the insulation has already failed, the insulation will have a resistance that will be very much lower, possibly in an order of a few Ohms only; often, the insulation is a polymer plastics material that can be decomposed to Carbon that is an electrical conductor. Such a traditional technique is not good at identifying gradual deterioration, and so is not very helpful at giving predictive warnings of insulation breakdown; moreover, these traditional techniques are generally only possible when the given motor, *mutatis mutandis* the given generator, is disconnected from the electricity supply powering the motor, *mutatis mutandis* is disconnected from the electricity network to which the given generator is providing power. Thus, it will be appreciated that the system **100** is capable of providing real-time continuous monitoring of insulation integrity of electrical motors, *mutatis mutandis* electrical generators.

A more sensitive technique employable in the system **100** for detecting earlier a deterioration of a given insulation, and hence giving an earlier warning of impending problems, relies on a characteristic that a given insulation gradually changes chemically over a period of time, for example due to chemical oxidation processing and/or metal migration processes. These chemical changes result in a change in its electrical behavior of the given insulation; principally, there is a reduction in a capacitance exhibited by the given insulation and a change, for example an increase or decrease in its resistive behavior, which results in a change in the phase angle (or "tan delta") between the voltage applied to the insulation and a (very small, for example nano-Amperes or microAmperes) leakage current flowing through it, when in use. The system **100** is configurable to operate to measure the phase angle (or "tan delta").

Computations implemented in the system **100** are based on a behavior of a given perfect insulator being conceptually thought of as an array of little capacitive elements connected in matrix manner in series and in parallel. On account of there being all capacitive elements, there is no DC current if a DC voltage is applied to the perfect insulator; however, when an alternating AC voltage is applied to the perfect insulator, there will be a capacitive current flowing that will increase as an alternating frequency increases (basis of computation: I = C.dv/dt, wherein I is a current, C is capacitance, and dv/dt is a temporal rate of voltage change applied to the capacitance C). As a pure capacitive current, this will flow at an orthogonal angle of 90 degrees (90°) to the applied voltage signal, with current leading voltage (engineering hint for understanding: *"CIVIL"* - in a capacitor, C, I before V; V before I in an inductor, L,; wherein V is an alternating sinusoidal voltage and I is an alternating sinusoidal current flowing). Over a period of time, when the perfect insulation is in use, the chemical change in the perfect insulation results in some of these little capacitive elements changing in nature to small resistive elements. While only a few of the capacitive elements have changed to being resistive elements, there is still no path for DC through to Earth through the aged perfect insulation, but the AC current will now have a different phase angle, as some of the AC current is now flowing through the resistive elements. By taking a plurality of readings at different frequencies, the values of the capacitive elements and resistive elements and phase angle can be calculated. Such a technique for assessing early stage insulation problems is already used by specialist bench testers, for testing motors in a workshop, or when still *in situ* but *de-energized* (namely, disconnected from an electrical supply). The specialist bench testers connect across between conductors of the motor and Earth. Conventionally, a series of test signals is applied at a range of frequencies from which the "health" (namely, a degree of ageing) of the insulation can be assessed. In contradistinction to such conventional approaches, the system **100** is capable of assessing the health (namely, "ageing") of the insulation during normal operation by utilizing measured harmonic components in an alternating voltage applied to the insulation, to assess the capacitive elements and resistive elements of the insulation, namely determinable from the aforesaid *"tan delta"* angle between current and voltage signals associated with the insulation.

Optionally, the system **100** measures transients when a given motor or generator coupled to the system **100** is started up into operation, for example rotationally accelerated from standstill to a rotating operational state. The aforesaid model used to describe the given motor or given generator (namely, as provided by the real-time model generation module **208** and utilized by the model comparison module **210** of the system **100**) beneficially includes parameters in the baseline that describe transient start-up, optionally shut-down, characteristics of the given motor or given generator. Such a manner of operation of the system **100** enables potential faults in switchgear to be identified that deliver or receive power to or from the given motor or generator, respectively.

The aforementioned multivariate cells are not limited to merely current and voltage measurements, whether obtained directly from measurements or generated by interpolation or extrapolation of data from neighboring multivariate cells, but optionally are additionally based on at least one of: temperature measurements, humidity measurements, vibration measurements. For example, temperature measurements allow coefficients of resistivity of winding elements to be taken into account, and humidity measurements enable insulation to be modelled more accurately (because polarized water molecules are able to modulate conduction characteristics of aged and compromised insulation materials).

## Claims

1. An electrical condition monitoring system (100) comprising:
a data server arrangement (108);
a data communication network arrangement (106);
at least one monitoring unit (104); and
at least one electrical device (102);
wherein:
the data server arrangement (108) is connected, via the data communication network (106), to the at least one monitoring unit (104) that is spatially local to a corresponding at least one electrical device (102);
wherein:
the at least one monitoring unit (104) is configured to monitor the at least one electrical device (102) when the at least one electrical device (102) is in operation; and
wherein:
(i) the at least one monitoring unit (104) includes a sensing arrangement (110) that temporally senses electrical signals associated with the at least one electrical device (102) and generates corresponding sensed data by processing the sensed electrical signals associated with the at least one electrical device (102), wherein the sensed data includes information associated with at least one of a supply of voltage or a supply of current to and/or from the at least one electrical device (102);
(ii) the at least one monitoring unit (104) connected with the at least one electrical device (102), wherein the at least one monitoring unit (104) includes a data processing arrangement (112) including a data processor that is configured to
- process the sensed data to generate a corresponding temporally-changing Fourier spectrum including signal harmonic components for at least one of the current or the voltage that is supplied to the at least one electrical device (102); and
- process temporal changes in magnitudes and frequencies of the signal harmonic components to generate analysis data representative of operation of the at least one electrical device (102); and
(iii) the at least one monitoring unit (104) is configured to communicate the analysis data to the data server arrangement (108) for:
(a) aggregating the analysis data received from the at least one monitoring unit (104) to obtain aggregated analysis data;
(b) generating aggregated performance results in respect of the at least one electrical device (102) based on the aggregated analysis data;
(c) providing control signals to the at least one monitoring unit (104) to monitor operation of the at least one electrical device (102) based on the aggregated performance results of the at least one electrical device (102);
(d) generating alerts relating to the at least one electrical device (102) when the aggregated performance results of the at least one electrical device (102) exceeds a threshold level, wherein the alerts represent at least one of: maintenance required for the at least one electrical device (102), replacement required for different parts of the at least one electrical device (102) or potential causes for failure of the at least one electrical device (102); and
(e) generating a condition assessment of the at least one electrical device (102), wherein a condition of the at least one electrical device is assessed based on comparison between a real-time model of the at least one electrical device (102) generated based on the analysis data with one or more stored models of the at least one electrical device (102),
**characterized in that** the data processing arrangement (112) of the at least one monitoring unit (104) is configured to at least partially filter out the changes in magnitudes and frequencies of the signal harmonic components caused due to electrical distortions present in the temporally-changing Fourier spectrum.

2. The electrical condition monitoring system (100) of claim 1, wherein the temporally-changing Fourier spectrum including signal harmonic components is calculated from at least one calculated residual current or residual voltage, wherein the at least one calculated residual current or residual voltage is calculated by comparing a model of predicted current or voltage with a measured current or voltage of the electrical device (102).

3. The electrical condition monitoring system (100) of claim 1 or 2 further comprising a user interface, wherein the data server arrangement (108) is configured to provide analysis data to the user interface that is configured for user entry of input for analyzing the analysis data and the data server arrangement (108) is configured to analyze the analysis data based on the input to obtain information indicative of an operating condition of the at least one electrical device (102).

4. The electrical condition monitoring system (100) of any one of the claims 1 to 3, wherein the data processing arrangement (112) of the at least one monitoring unit (104) is configured to access the one or more stored models of operation of the at least one electrical device (102), and to compare the real-time model with the one or more stored models to generate information indicative of an operating condition of the at least one electrical device (102).

5. The electrical condition monitoring system (100) of claim 3 or claim 4, when dependent upon claim 3, wherein the user interface is configured for user entry of user defined parameters for generating a range of multivariate cells in a database of the electrical condition monitoring system (100) and the data processing arrangement (112) is configured to update the sensed data of the electrical device (102) in their respective multivariate cells, wherein the multivariate cells store the temporally-changing Fourier spectrum associated with the sensed data and the one or more stored models associated with the electrical device (102).

6. The electrical condition monitoring system (100) of any one of the claims 1 to 5, wherein the data processing arrangement (112) is configured to generate the real-time model of the at least one electrical device (102) based on the analysis data.

7. The electrical condition monitoring system (100) of any one of the preceding claims, wherein the data processing arrangement (112) is configured to compute parameter differences between the real-time model and the one or more stored models, and to generate a predictive model describing the parameter difference between the real-time model and the one or more stored models to generate the information indicative of an operating condition of the at least one electrical device (102).

8. The electrical condition monitoring system (100) of claim 7, wherein the data processing arrangement (112) is configured to generate, from the predictive model, one or more alerts relating to:
(a) energy utilization trends of the at least one electrical device (102);
(b) Carbon Dioxide (equivalent) generation being caused by the at least one electrical device (102);
(c) maintenance, replacement or repair of the at least one electrical device (102); and
(d) a state of insulation of the electrical device (102).

9. The electrical condition monitoring system (100) of any one of the preceding claims, wherein the at least one electrical device (102) includes at least one of: a synchronous 1-phase electrical motor, a synchronous multi-phase electrical motor, a synchronous 3-phase electrical motor, an asynchronous 1-phase motor, an asynchronous 3-phase motor, a generator, an alternator, a switched reluctance motor, a switched stepper motor, a D.C. electrical motor, a compressor, a pump, an air conditioner, a ventilator, a refrigerator, a washing machine, a television, a vacuum cleaner, a wind turbine generator, a tidal turbine generator, a geothermal turbine generator, a hydroelectric generator, an ocean wave electrical generator, a heliostat electrical generator, a photovoltaic panel electrical generator, or a heater.

10. The electrical condition monitoring system (100) of claim 3, wherein the user interface is configured for obtaining user entry of machine parameters describing the at least one electrical device (102), wherein the machine parameters include at least one of: generic nominal operating voltage, generic nominal operating current, generic nominal supply frequency, generic nominal rotational speed, number of vanes on an impeller of the at least one electrical device (102), bearing type codes of the at least one electrical device (102) or belt drive dimensions of the at least one electrical device (102).

11. The electrical condition monitoring system (100) of claim 3, claim 9, when dependent upon claim 3, or claim 10, wherein the user interface is configured to allow user-selection for implementing D-Q phase and A-B phase transformation, computed in the data processing arrangement (112), of the sensed data wherein the D-Q phase transformation transfers three-phase stator and rotor quantities into a single rotating reference frame to eliminate effect of time-varying inductances, wherein the A-B phase transformation refers to a mathematical transformation that is implemented to simplify an analysis of three-phase stator and rotor.

12. The electrical condition monitoring system (100) of any one of the preceding claims, wherein the data processing arrangement (112) is configured to create a linear model of one or more relationships between voltage and current signals obtained from the at least one electrical device (102).

13. The electrical condition monitoring system (100) of claim 3 or any of claims 4-12, when dependent upon claim 3, wherein the data processing arrangement (112) is configured to:
(i) generate a linear model describing the at least one electrical device (102);
(ii) use the linear model to create a model of predicted current of the at least one electrical device (102) from measured voltages obtained from the at least one electrical device (102);
(iii) compare the model of predicted current with a measured current of the at least one electrical device (102) to create a residual current data;
(iv) perform Fast Fourier Transform (FFT) on the residual current data to create the temporally-changing Fourier spectrum;
(v) identify at least one local maximum on the temporally-changing Fourier spectrum by analyzing the temporally-changing Fourier spectrum that are plotted based on the sensed data using a crawling technique, wherein an entirety of the temporally changing Fourier spectrum is divided into local maxima joined to one another at local minima to identify at least one local maximum corresponding to a phenomenon on the temporally-changing Fourier spectrum, wherein the crawling technique identifies the at least one local maximum on the temporally- changing Fourier spectrum by determining a value that increases towards the at least one local maximum or a value that decreases from the at least one local maximum;
(vi) calculate locations (i.e. frequencies) on the temporally-changing Fourier spectrum where the same phenomenon appears to create a family of possible local maxima;
(vii) identify a significant local maximum from the family of possible local maxima corresponding to the phenomenon and generate the analysis data from a magnitude of the significant local maximum, wherein the significant local maximum is identified in terms of an absolute value or number of standard deviations from a mean value: and
(viii) label the significant local maximum with the phenomenon description in the user interface for presenting to the user.

14. A method (1000) of using the electrical condition monitoring system (100) according to any of claims 1 to 13, wherein the method includes:
(i) arranging the at least one monitoring unit (104) to include the sensing arrangement (110) that temporally senses electrical signals associated with the at least one electrical device and generates corresponding sensed data by processing the sensed electrical signals associated with the at least one electrical device (102), wherein the sensed data includes information associated with at least one of a supply of voltage or a supply of current to and/or from the at least one electrical device (102);
(ii) arranging the at least one monitoring unit (104) to include the data processing arrangement (112) including the data processor that is configured to process the sensed data to generate a corresponding temporally changing Fourier spectrum including signal harmonic components for at least one of the current or the voltage that is supplied to the at least one electrical device (102) and to process temporal changes in magnitudes and frequencies of the signal harmonic components to generate analysis data representative of operation of the at least one electrical device (102); and
(iii) configuring the at least one monitoring unit (104) to communicate the analysis data to the data server arrangement (108) for:
(a) aggregating the analysis data received from the at least one monitoring unit (104) to obtain aggregated analysis data;
(b) generating aggregated performance results in respect of the at least one electrical device (102) based on the aggregated analysis data;
(c) providing control signals to the at least one monitoring unit (104) to monitor operation of the at least one electrical device (102) based on the aggregated performance results of the at least one electrical device (102);
(d) generating alerts relating to the at least one electrical device (102) when the aggregated performance results of the at least one electrical device (102) exceeds a threshold level, wherein the alerts represent at least one of: maintenance required for the at least one electrical device (102), replacement required for different parts of the at least one electrical device (102) or potential causes for failure of the at least one electrical device (102); and
(e) a condition assessment of the at least one electrical device (102), wherein a condition of the at least one electrical device (102) is assessed based on comparison between a real-time model of the at least one electrical device (102) generated based on the analysis data with one or more stored models of the at least one electrical device (102),
**characterized in that** the data processing arrangement of the at least one monitoring unit is configured to at least partially filter out the changes in magnitudes and frequencies of the signal harmonic components caused due to electrical distortions present in the temporally-changing Fourier spectrum.

15. A computer program product comprising a non-transitory computer-readable storage medium having computer-readable instructions stored thereon to cause the system of claim 1 to execute all the steps of the method of claim 14.

## Patentansprüche

1. Überwachungssystem (100) eines elektrischen Zustands, umfassend:
eine Datenserveranordnung (108);
eine Datenkommunikationsnetzanordnung (106);
mindestens eine Überwachungseinheit (104); und
mindestens eine elektrische Vorrichtung (102);
wobei:
die Datenserveranordnung (108), über das Datenkommunikationsnetz (106), mit der mindestens einen Überwachungseinheit (104) verbunden ist, die zu einer entsprechenden mindestens einen elektrischen Vorrichtung (102) räumlich lokal ist;
wobei:
die mindestens eine Überwachungseinheit (104) konfiguriert ist, um die mindestens eine elektrische Vorrichtung (102) zu überwachen, wenn die mindestens eine elektrische Vorrichtung (102) in Betrieb ist; und
wobei:
(i) die mindestens eine Überwachungseinheit (104) eine Erfassungsanordnung (110) einschließt, die elektrische Signale, die der mindestens einen elektrischen Vorrichtung (102) zugeordnet sind, zeitlich erfasst und entsprechende erfasste Daten durch Verarbeiten der erfassten elektrischen Signale generiert, die der mindestens einen elektrischen Vorrichtung (102) zugeordnet sind, wobei die erfassten Daten Informationen einschließen, die mindestens eines von einer Spannungsversorgung oder einer Stromversorgung zu und/oder von der mindestens einen elektrischen Vorrichtung (102) zugeordnet sind;
(ii) wobei die mindestens eine Überwachungseinheit (104) mit der mindestens einen elektrischen Vorrichtung (102) verbunden ist, wobei die mindestens eine Überwachungseinheit (104) eine Datenverarbeitungsanordnung (112) einschließt, die einen Datenprozessor einschließt, der konfiguriert ist zum
- Verarbeiten der erfassten Daten, um ein entsprechendes zeitlich veränderliches Fourier-Spektrum zu generieren, das Signaloberschwingungskomponenten für mindestens einen von dem Strom oder der Spannung einschließt, mit dem/der die mindestens eine elektrische Vorrichtung (102) versorgt wird; und
- Verarbeiten von zeitlichen Veränderungen von Größen und Frequenzen der Signaloberschwingungskomponenten, um Analysedaten zu generieren, die für den Betrieb der mindestens einen elektrischen Vorrichtung (102) darstellend sind; und
(iii) die mindestens eine Überwachungseinheit (104) konfiguriert ist, um die Analysedaten an die Datenserveranordnung (108) zu kommunizieren:
(a) Aggregieren der Analysedaten, die von der mindestens einen Überwachungseinheit (104) empfangen werden, um aggregierte Analysedaten zu erhalten;
(b) Generieren aggregierter Leistungsergebnisse in Bezug auf die mindestens eine elektrische Vorrichtung (102) basierend auf den aggregierten Analysedaten;
(c) Bereitstellen von Steuersignalen an die mindestens eine Überwachungseinheit (104), um den Betrieb der mindestens einen elektrischen Vorrichtung (102) basierend auf den aggregierten Leistungsergebnissen der mindestens einen elektrischen Vorrichtung (102) zu überwachen;
(d) Generieren von Warnungen, die sich auf die mindestens eine elektrische Vorrichtung (102) beziehen, wenn die aggregierten Leistungsergebnisse der mindestens einen elektrischen Vorrichtung (102) einen Schwellenwert überschreiten, wobei die Warnungen mindestens eines darstellen von: einer Wartung, die für die mindestens eine elektrische Vorrichtung (102) erforderlich ist, einem Austausch, der für unterschiedliche Teile der mindestens einen elektrischen Vorrichtung (102) erforderlich ist, oder potenzieller Ursachen für einen Ausfall der mindestens einen elektrischen Vorrichtung (102); und
(e) Generieren einer Zustandsbewertung der mindestens einen elektrischen Vorrichtung (102), wobei ein Zustand der mindestens einen elektrischen Vorrichtung basierend auf einem Vergleich zwischen einem Echtzeitmodell der mindestens einen elektrischen Vorrichtung (102), das basierend auf den Analysedaten generiert wird, mit einem oder mehreren gespeicherten Modellen der mindestens einen elektrischen Vorrichtung (102) bewertet wird,
**dadurch gekennzeichnet, dass** die Datenverarbeitungsanordnung (112) der mindestens einen Überwachungseinheit (104) konfiguriert ist, um mindestens teilweise die Veränderungen bei den Größen und Frequenzen der Signaloberwellenkomponenten herauszufiltern, die aufgrund elektrischer Verzerrungen verursacht werden, die in dem zeitlich veränderlichen Fourier-Spektrum vorhanden sind.

2. Überwachungssystem (100) des elektrischen Zustands nach Anspruch 1, wobei das zeitlich veränderliche Fourier-Spektrum, das Signaloberschwingungskomponenten einschließt, aus mindestens einem berechneten Reststrom oder einer berechneten Restspannung berechnet wird, wobei der mindestens eine berechnete Fehlerstrom oder die mindestens eine berechnete Restspannung durch Vergleichen eines Modells eines vorhergesagten Stroms oder einer vorhergesagten Spannung mit einem gemessenen Strom oder einer gemessenen Spannung der elektrischen Vorrichtung (102) berechnet wird.

3. Überwachungssystem (100) des elektrischen Zustands nach Anspruch 1 oder 2, ferner umfassend eine Benutzerschnittstelle, wobei die Datenserveranordnung (108) konfiguriert ist, um Analysedaten an die Benutzerschnittstelle bereitzustellen, die für den Benutzereintrag einer Eingabe zum Analysieren der Analysedaten konfiguriert ist, und die Datenserveranordnung (108) konfiguriert ist, um die Analysedaten basierend auf der Eingabe zu analysieren, um Informationen zu erhalten, die einen Betriebszustand der mindestens einen elektrischen Vorrichtung (102) angeben.

4. Überwachungssystem (100) des elektrischen Zustands nach einem der Ansprüche 1 bis 3, wobei die Datenverarbeitungsanordnung (112) der mindestens einen Überwachungseinheit (104) konfiguriert ist, um auf das eine oder die mehreren gespeicherten Betriebsmodelle der mindestens einen elektrischen Vorrichtung (102) zuzugreifen, und um das Echtzeitmodell mit dem einen oder den mehreren gespeicherten Modellen zu vergleichen, um Informationen zu generieren, die mindestens einen Betriebszustand der einen elektrischen Vorrichtung (102) angeben.

5. Überwachungssystem (100) des elektrischen Zustands nach Anspruch 3 oder 4, wenn abhängig von Anspruch 3, wobei die Benutzerschnittstelle für eine Benutzereingabe von benutzerdefinierten Parametern zum Generieren eines Bereichs von multivariaten Zellen in einer Datenbank des Überwachungssystems (100) des elektrischen Zustands konfiguriert ist und die Datenverarbeitungsanordnung (112) konfiguriert ist, um die erfassten Daten der elektrischen Vorrichtung (102) in ihren jeweiligen multivariaten Zellen zu aktualisieren, wobei die multivariaten Zellen das zeitlich veränderliche Fourier-Spektrum, das den erfassten Daten zugeordnet ist, und das eine oder die mehreren gespeicherten Modelle speichern, die der elektrischen Vorrichtung (102) zugeordnet sind.

6. Überwachungssystem (100) des elektrischen Zustands nach einem der Ansprüche 1 bis 5, wobei die Datenverarbeitungsanordnung (112) konfiguriert ist, um das Echtzeitmodell der mindestens einen elektrischen Vorrichtung (102) basierend auf den Analysedaten zu generieren.

7. Überwachungssystem (100) des elektrischen Zustands nach einem der vorstehenden Ansprüche, wobei die Datenverarbeitungsanordnung (112) konfiguriert ist, um Parameterunterschiede zwischen dem Echtzeitmodell und dem einen oder den mehreren gespeicherten Modellen zu berechnen, und um ein Vorhersagemodell zu generieren, das den Parameterunterschied zwischen dem Echtzeitmodell und dem einen oder den mehreren gespeicherten Modellen beschreibt, um die Informationen zu generieren, die einen Betriebszustand der mindestens einen elektrischen Vorrichtung (102) angeben.

8. Überwachungssystem (100) des elektrischen Zustands nach Anspruch 7, wobei die Datenverarbeitungsanordnung (112) konfiguriert ist, um aus dem Vorhersagemodell ein oder mehrere Warnungen zu generieren, die sich beziehen auf:
(a) Energienutzungstrends der mindestens einen elektrischen Vorrichtung (102);
(b) Kohlendioxid-(äquivalente) Generierung, die durch die mindestens eine elektrische Vorrichtung (102) verursacht wird;
(c) Wartung, Austausch oder Reparatur der mindestens einen elektrischen Vorrichtung (102); und
(d) einen Isolationsstatus der elektrischen Vorrichtung (102).

9. Überwachungssystem (100) des elektrischen Zustands nach einem der vorstehenden Ansprüche, wobei die mindestens eine elektrische Vorrichtung (102) mindestens eines einschließt von: einem synchronen 1-phasigen Elektromotor, einem synchronen Mehrphasenelektromotor, einem synchronen 3-phasigen Elektromotor, einem asynchronen 1-phasigen Motor, einem asynchronen 3-Phasen-Motor, einem Generator, einem Wechselstromerzeuger, einem geschalteten Reluktanzmotor, einem geschalteten Schrittmotor, einem D.C-Elektromotor, einem Kompressor, einer Pumpe, einer Klimaanlage, einem Ventilator, einem Kühlschrank, einer Waschmaschine, einem Fernseher, einem Staubsauger, einem Windturbinengenerator, einem Tidalturbinengenerator, einem geothermischen Turbinengenerator, einem Wasserkraftgenerator, einem elektrischen Ozeanwellengenerator, einem elektrischen Heliostatgenerator, einem elektrischen Solarmodulgenerator oder einer Heizung.

10. Überwachungssystem (100) des elektrischen Zustands nach Anspruch 3, wobei die Benutzerschnittstelle zum Erhalten der Benutzereingabe von Maschinenparametern konfiguriert ist, die die mindestens elektrische Vorrichtung (102) beschreiben, wobei die Maschinenparameter mindestens eines einschließen von: einer generischen Nennbetriebsspannung, eines generischen Nennbetriebsstroms, einer generischen Nennversorgungsfrequenz, einer generischen Nenndrehzahl, einer Anzahl von Flügeln an einem Laufrad der mindestens einen elektrischen Vorrichtung (102), Lagertypcodes der mindestens einen elektrischen Vorrichtung (102) oder Riemenantriebsabmessungen der mindestens einen elektrischen Vorrichtung (102).

11. Überwachungssystem (100) des elektrischen Zustands nach Anspruch 3, Anspruch 9, wenn abhängig von Anspruch 3 oder 10, wobei die Benutzerschnittstelle konfiguriert ist, um eine Benutzerauswahl zum Implementieren von D-Q-Phasen- und A-B-Phasentransformation zu ermöglichen, die in der Datenverarbeitungsanordnung (112) der erfassten Daten berechnet werden, wobei die D-Q-Phasentransformation dreiphasige Stator- und Rotormengen in einen einzigen rotierenden Referenzrahmen überträgt, um eine Wirkung zeitlich variierender Induktivitäten zu eliminieren, wobei sich die A-B-Phasentransformation auf eine mathematische Transformation bezieht, die implementiert ist, um eine Analyse von einem dreiphasigen Stator und Rotor zu vereinfachen.

12. Überwachungssystem (100) des elektrischen Zustands nach einem der vorstehenden Ansprüche, wobei die Datenverarbeitungsanordnung (112) konfiguriert ist, um ein lineares Modell einer oder mehrerer Beziehungen zwischen Spannungs- und Stromsignalen zu erstellen, die von der mindestens einen elektrischen Vorrichtung (102) erhalten werden.

13. Überwachungssystem (100) des elektrischen Zustands nach Anspruch 3 oder einem der Ansprüche 4 bis 12, wenn abhängig von Anspruch 3, wobei die Datenverarbeitungsanordnung (112) konfiguriert ist zum:
(i) Generieren eines linearen Modells, das die mindestens eine elektrische Vorrichtung (102) beschreibt;
(ii) Verwenden des linearen Modells, um ein Modell des vorhergesagten Stroms der mindestens einen elektrischen Vorrichtung (102) aus den gemessenen Spannungen zu erstellen, die von der mindestens einen elektrischen Vorrichtung (102) erhalten werden;
(iii) Vergleichen des Modells des vorhergesagten Stroms mit einem gemessenen Strom der mindestens einen elektrischen Vorrichtung (102), um Reststromdaten zu erstellen;
(iv) Durchführen einer Fast-Fourier-Transformation (FFT) auf den Reststromdaten, um das zeitlich veränderliche Fourier-Spektrum zu erzeugen;
(v) Identifizieren mindestens eines lokalen Maximums auf dem zeitlich veränderlichen Fourier-Spektrum durch Analysieren des zeitlich veränderlichen Fourier-Spektrums, das basierend auf den erfassten Daten unter Verwendung einer Crawling-Technik aufgezeichnet wird, wobei eine Gesamtheit des zeitlich veränderlichen Fourier-Spektrums in lokale Maxima unterteilt ist, die an lokalen Minima miteinander verbunden sind, um mindestens ein lokales Maximum zu identifizieren, das einem Phänomen auf dem zeitlich veränderlichen Fourier-Spektrum entspricht, wobei die Crawling-Technik das mindestens eine lokale Maximum auf dem zeitlich veränderlichen Fourier-Spektrum durch Bestimmen eines Werts, der sich in Richtung des mindestens einen lokalen Maximums steigert, oder eines Werts identifiziert, der sich von dem mindestens einen lokalen Maximum verringert;
(vi) Berechnen von Positionen (i.e. Frequenzen) auf dem zeitlich veränderlichen Fourier-Spektrum, an denen das gleiche Phänomen auftritt, um eine Familie möglicher lokaler Maxima zu erstellen;
(vii) Identifizieren eines signifikanten lokalen Maximums aus der Familie möglicher lokaler Maxima, die dem Phänomen entsprechen, und Generieren der Analysedaten aus einer Größe des signifikanten lokalen Maximums, wobei das signifikante lokale Maximum in Form von einem Absolutwert oder einer Anzahl von Standardabweichungen von einem Mittelwert identifiziert wird: und
(viii) Kennzeichnen des signifikanten lokalen Maximums mit einer Beschreibung des Phänomens in der Benutzerschnittstelle zum Darstellen an den Benutzer.

14. Verfahren (1000) zum Verwenden des Überwachungssystems des elektrischen Zustands nach einem der Ansprüche 1 bis 13, wobei das Verfahren einschließt:
(i) Anordnen der mindestens einen Überwachungseinheit (104), um die Erfassungsanordnung (110) einzuschließen, die elektrische Signale, die der mindestens einen elektrischen Vorrichtung zugeordnet sind, zeitlich erfasst und entsprechende erfasste Daten durch Verarbeiten der erfassten elektrischen Signale generiert, die der mindestens einen elektrischen Vorrichtung (102) zugeordnet sind, wobei die erfassten Daten Informationen einschließen, die mindestens eines von einer Spannungsversorgung oder einer Stromversorgung zu und/oder von der mindestens einen elektrischen Vorrichtung (102) zugeordnet sind;
(ii) Anordnen der mindestens einen Überwachungseinheit (104), um die Datenverarbeitungsanordnung (112) einzuschließen, die den Datenprozessor einschließt, der konfiguriert ist, um die erfassten Daten zu verarbeiten, um ein entsprechendes zeitlich veränderliches Fourier-Spektrum zu generieren, das Signaloberschwingungskomponenten für mindestens einen von dem Strom oder der Spannung einschließt, mit dem/der die mindestens eine elektrische Vorrichtung (102) versorgt wird, und um die zeitlichen Veränderungen in Größen und Frequenzen der Signaloberschwingungskomponenten zu verarbeiten, um Analysedaten zu generieren, die für den Betrieb der mindestens einen elektrischen Vorrichtung (102) darstellend sind; und
(iii) Konfigurieren der mindestens einen Überwachungseinheit (104), um die Analysedaten an die Datenserveranordnung (108) zu kommunizieren zum:
(a) Aggregieren der Analysedaten, die von der mindestens einen Überwachungseinheit (104) empfangen werden, um aggregierte Analysedaten zu erhalten;
(b) Generieren aggregierter Leistungsergebnisse in Bezug auf die mindestens eine elektrische Vorrichtung (102) basierend auf den aggregierten Analysedaten;
(c) Bereitstellen von Steuersignalen an die mindestens eine Überwachungseinheit (104), um den Betrieb der mindestens einen elektrischen Vorrichtung (102) basierend auf den aggregierten Leistungsergebnissen der mindestens einen elektrischen Vorrichtung (102)zu überwachen;
(d) Generieren von Warnungen, die sich auf die mindestens eine elektrische Vorrichtung (102) beziehen, wenn die aggregierten Leistungsergebnisse der mindestens einen elektrischen Vorrichtung (102) einen Schwellenwert überschreiten, wobei die Warnungen mindestens eines darstellen von: einer Wartung, die für die mindestens eine elektrische Vorrichtung (102) erforderlich ist, Austausch, dass für unterschiedliche Teile der mindestens einen elektrischen Vorrichtung (102) erforderlich ist, oder potenzieller Ursachen für einen Ausfall der mindestens einen elektrischen Vorrichtung (102); und
(e) eine Zustandsbewertung der mindestens einen elektrischen Vorrichtung (102), wobei ein Zustand der mindestens einen elektrischen Vorrichtung (102) basierend auf dem Vergleich zwischen einem Echtzeitmodell der mindestens einen elektrischen Vorrichtung (102), das basierend auf den Analysedaten generiert wird, mit einem oder mehreren gespeicherten Modellen der mindestens einen elektrischen Vorrichtung (102) bewertet wird,
**dadurch gekennzeichnet, dass** die Datenverarbeitungsanordnung der mindestens einen Überwachungseinheit konfiguriert ist, um mindestens teilweise die Veränderungen bei den Größen und Frequenzen der Signaloberwellenkomponenten herauszufiltern, die durch elektrische Verzerrungen verursacht werden, die in dem zeitlich veränderlichen Fourier-Spektrum vorhanden sind.

15. Computerprogrammprodukt, umfassend ein nicht flüchtiges computerlesbares Speichermedium, das computerlesbare Anweisungen darauf gespeichert aufweist, um das System nach Anspruch 1 zu veranlassen, alle Schritte des Verfahrens nach Anspruch 14 auszuführen.

## Revendications

1. Système de surveillance de condition électrique (100) comprenant :
un agencement de serveur de données (108) ;
un agencement de réseau de communication de données (106) ;
au moins une unité de surveillance (104) ; et
au moins un dispositif électrique (102) ;
dans lequel :
l'agencement de serveur de données (108) est connectée, par l'intermédiaire du réseau de communication de données (106), à l'au moins une unité de surveillance (104) qui est spatialement locale à au moins un dispositif électrique correspondant (102) ;
dans lequel :
l'au moins une unité de surveillance (104) est configurée pour surveiller l'au moins un dispositif électrique (102) lorsque l'au moins un dispositif électrique (102) est en fonctionnement ; et
dans lequel :
(i) l'au moins une unité de surveillance (104) comporte un agencement de détection (110) qui détecte temporellement des signaux électriques associés à l'au moins un dispositif électrique (102) et génère des données détectées correspondantes en traitant les signaux électriques détectés associés à l'au moins un dispositif électrique (102), dans lequel les données détectées comportent des informations associées à au moins l'un parmi une alimentation en tension ou une alimentation en courant vers et/ou depuis l'au moins un dispositif électrique (102) ;
(ii) l'au moins une unité de surveillance (104) connectée à l'au moins un dispositif électrique (102), dans lequel l'au moins une unité de surveillance (104) comporte un agencement de traitement de données (112) comportant un processeur de données qui est configuré pour
- traiter les données détectées pour générer un spectre de Fourier de changement temporel correspondant y compris des composantes harmoniques de signal pour au moins l'un parmi le courant ou la tension qui est fourni à l'au moins un dispositif électrique (102) ; et
- traiter des changements temporels des amplitudes et des fréquences des composantes harmoniques de signal pour générer des données d'analyse représentatives du fonctionnement de l'au moins un dispositif électrique (102) ; et
(iii) l'au moins une unité de surveillance (104) est configurée pour communiquer les données d'analyse à l'agencement de serveur de données (108) pour :
(a) agréger des données d'analyse reçues de l'au moins une unité de surveillance (104) pour obtenir des données d'analyse agrégées ;
(b) générer des résultats de performance agrégés en ce qui concerne l'au moins un dispositif électrique (102) sur la base des données d'analyse agrégées ;
(c) fournir des signaux de commande à l'au moins une unité de surveillance (104) pour surveiller le fonctionnement de l'au moins un dispositif électrique (102) sur la base des résultats de performance agrégés de l'au moins un dispositif électrique (102) ;
(d) générer des alertes relatives à l'au moins un dispositif électrique (102) lorsque les résultats de performance agrégés de l'au moins un dispositif électrique (102) dépassent un niveau de seuil, les alertes représentant au moins l'un parmi : une maintenance requise pour l'au moins un dispositif électrique (102), un remplacement requis pour différentes parties de l'au moins un dispositif électrique (102) ou des causes potentielles pour une défaillance de l'au moins un dispositif électrique (102) ; et
(e) générer une évaluation de la condition de l'au moins un dispositif électrique (102), dans lequel une condition de l'au moins un dispositif électrique est évaluée sur la base d'une comparaison entre un modèle en temps réel de l'au moins un dispositif électrique (102) généré sur la base des données d'analyse avec un ou plusieurs modèles stockés de l'au moins un dispositif électrique (102),
**caractérisé en ce que** l'agencement de traitement de données (112) de l'au moins une unité de surveillance (104) est configurée pour filtrer au moins partiellement les changements d'amplitudes et de fréquences des composantes harmoniques de signal causées par une distorsion électrique présente dans le spectre de Fourier à changement temporel ;

2. Système de surveillance de condition électrique (100) selon la revendication 1, dans lequel le spectre de Fourier à changement temporel y compris des composantes harmoniques de signal est calculé à partir d'au moins un courant résiduel ou de tension résiduelle calculé, dans lequel l'au moins un courant résiduel ou tension résiduelle calculé est calculé en comparant un modèle de courant ou tension prédit avec un courant ou une tension mesuré du dispositif électrique (102).

3. Système de surveillance de condition électrique (100) selon la revendication 1 ou 2 comprenant en outre une interface utilisateur, dans lequel l'agencement de serveur de données (108) est configuré pour fournir des données d'analyse à l'interface utilisateur qui est configurée pour une entrée d'utilisateur d'entrée en vue d'analyser les données d'analyse et l'agencement de serveur de données (108) est configuré pour analyser les données d'analyse sur la base de l'entrée pour obtenir des informations indiquant une condition de fonctionnement de l'au moins un dispositif électrique (102).

4. Système de surveillance de condition électrique (100) selon l'une quelconque des revendications 1 à 3, dans lequel l'agencement de traitement de données (112) de l'au moins une unité de surveillance (104) est configuré pour accéder au ou aux modèles de fonctionnement stockés de l'au moins un dispositif électrique (102), et pour comparer le modèle en temps réel avec le ou les modèles stockés pour générer des informations indiquant une condition de fonctionnement de l'au moins un dispositif électrique (102).

5. Système de surveillance de condition électrique (100) selon la revendication 3 ou la revendication 4, lorsqu'il dépend de la revendication 3, dans lequel l'interface utilisateur est configurée pour une entrée d'utilisateur de paramètres définis par l'utilisateur permettant de générer une plage de cellules multivariées dans une base de données (202) du système de surveillance d'état électrique (100) et l'agencement de traitement de données (112) est configuré pour mettre à jour les données détectées du dispositif électrique (102) dans leurs cellules multivariées respectives, dans lequel les cellules multivariées stockent le spectre de Fourier à changement temporel associé aux données détectées et au ou aux modèles stockés associés au dispositif électrique (102).

6. Système de surveillance de condition électrique (100) selon l'une quelconque des revendications 1 à 5, dans lequel l'agencement de traitement de données (112) est configuré pour générer le modèle en temps réel de l'au moins un dispositif électrique (102) sur la base des données d'analyse.

7. Système de surveillance de condition électrique (100) selon l'une quelconque des revendications précédentes, dans lequel l'agencement de traitement de données (112) est configuré pour calculer des différences de paramètres entre le modèle en temps réel et le ou les modèles stockés, et pour générer un modèle prédictif décrivant la différence de paramètres entre le modèle en temps réel et les ou les modèles stockés pour générer les informations indiquant une condition de fonctionnement de l'au moins un dispositif électrique (102).

8. Système de surveillance de condition électrique (100) selon la revendication 7, dans lequel l'agencement de traitement de données (112) est configuré pour générer, à partir du modèle prédictif, une ou plusieurs alertes relatives à :
(a) des tendances d'utilisation d'énergie de l'au moins un dispositif électrique (102) ;
(b) la génération de dioxyde de carbone (équivalent) étant provoquée par l'au moins un dispositif électrique (102) ;
(c) la maintenance, le remplacement ou la réparation du dispositif électrique (102) ; et
(d) un état d'isolation du dispositif électrique (102).

9. Système de surveillance de condition électrique (100) selon l'une quelconque des revendications précédentes, dans lequel l'au moins un dispositif électrique (102) comporte au moins l'un parmi : un moteur électrique monophasé synchrone, un moteur électrique polyphasé synchrone, un moteur électrique triphasé synchrone, un moteur monophasé asynchrone, un moteur asynchrone triphasé, un générateur, un alternateur, un moteur à réluctance commutée, un moteur pas à pas commuté, un moteur électrique à courant continu, un compresseur, une pompe, un climatiseur, un ventilateur, un réfrigérateur, une machine à laver, une télévision, un aspirateur, un générateur d'éolienne, un générateur marémotrice, un générateur électrique géothermique, une génératrice hydroélectrique, un générateur électrique de vagues océaniques, un générateur électrique de panneau photovoltaïque, un générateur électrique héliostat, un générateur de panneau solaire photovoltaïque ou un dispositif de chauffage.

10. Système de surveillance de condition électrique (100) selon la revendication 3, dans lequel l'interface utilisateur est configurée pour obtenir une entrée d'utilisateur de paramètres de machine décrivant l'au moins un dispositif électrique (102), dans lequel les paramètres de machine comprennent au moins l'un parmi : une tension de fonctionnement nominale générique, un courant de fonctionnement nominal générique, une fréquence d'alimentation nominale générique, une vitesse de rotation nominale générique, un nombre d'aubes sur une roue de l'au moins un dispositif électrique (102), portant des codes de type de l'au moins un dispositif électrique (102) ou des dimensions d'entraînement de bande de l'au moins un dispositif électrique (102).

11. Système de surveillance de condition électrique (100) selon la revendication 3, la revendication 9, lorsqu'il dépend de la revendication 3, ou de la revendication 10, dans lequel l'interface utilisateur est configurée pour permettre une sélection d'utilisateur en vue de mettre en oeuvre une phase D-Q et une transformation de phase A-B, calculée dans l'agencement de traitement de données (112), des données détectées dans lequel la transformation de phase D-Q transfère des quantités triphasées de stator et de rotor dans un seul cadre de référence rotatif pour éliminer l'effet des inductances variant dans le temps, dans lequel la transformation de phase A-B fait référence à une transformation mathématique qui est mise en oeuvre pour simplifier une analyse de stator et de rotor triphasés.

12. Système de surveillance de condition électrique (100) selon l'une quelconque des revendications précédentes, dans lequel l'agencement de traitement de données (112) est configuré pour créer un modèle linéaire d'une ou de plusieurs relations entre des signaux de tension et de courant obtenus à partir du dispositif électrique (102).

13. Système de surveillance de condition électrique (100) selon la revendication 3 ou l'une quelconque des revendications 4 à 12, lorsqu'il dépend de la revendication 3, dans lequel l'agencement de traitement de données (112) est configuré pour :
(i) générer un modèle linéaire décrivant l'au moins un dispositif électrique (102) ;
(ii) utiliser le modèle linéaire pour créer un modèle de courant prédit de l'au moins un dispositif électrique (102) à partir de tensions mesurées obtenues à partir du dispositif électrique (102) ;
(iii) comparer le modèle de courant prédit avec un courant mesuré du dispositif électrique (102) pour créer des données de courant résiduel ;
(iv) effectuer une transformée de Fourier rapide (FFT) sur les données de courant résiduel pour créer le spectre de Fourier à changement temporel ;
(v) identifier au moins un maximum local sur le spectre de Fourier à changement temporel en analysant le spectre de Fourier à changement temporel qui sont tracés sur la base des données détectées en utilisant une technique de rampage, dans lequel une totalité du spectre de Fourier à changement temporel est divisée en maximums locaux joints les uns aux autres au niveau de minimums locaux pour identifier au moins un maximum local correspondant à un phénomène sur le spectre de Fourier à changement temporel, dans lequel la technique de rampage identifie l'au moins un maximum local sur le spectre de Fourier à changement temporel en déterminant une valeur qui augmente vers l'au moins un maximum local ou une valeur qui diminue de l'au moins un maximum local ;
(vi) calculer des emplacements (c'est-à-dire des fréquences) sur le spectre de Fourier à changement temporel où le même phénomène apparaît pour créer une famille de maximums locaux possibles ;
(vii) identifier un maximum local significatif de la famille des maximums locaux possibles correspondant au phénomène et générer les données d'analyse à partir d'une amplitude du maximum local significatif, dans lequel le maximum local significatif est identifié en termes de valeur absolue ou de nombre d'écarts types à partir d'une valeur moyenne ; et
(viii) marquer le maximum local important par la description de phénomène dans l'interface utilisateur en vue de présentation à l'utilisateur.

14. Procédé (1000) d'utilisation du système de surveillance de condition électrique selon l'une quelconque des revendications 1 à 13, dans lequel le procédé comporte :
(i) l'agencement de l'au moins une unité de surveillance (104) pour comporter l'agencement de détection (110) qui détecte temporellement des signaux électriques associés à l'au moins un dispositif électrique et génère des données détectées correspondantes en traitant les signaux électriques détectés associés à l'au moins un dispositif électrique (102), dans lequel les données détectées comportent des informations associées à au moins l'un parmi une alimentation en tension ou une alimentation en courant vers et/ou depuis l'au moins un dispositif électrique (102) ;
(ii) l'agencement de l'au moins une unité de surveillance (104) pour comporter l'agencement de traitement de données (112) comportant un processeur de données qui est configuré pour traiter les données détectées pour générer un spectre de Fourier à changement temporel correspondant y compris des composantes harmoniques de signal pour au moins l'un parmi le courant ou la tension qui est fourni vers et/ou depuis l'au moins un dispositif électrique (102) et pour traiter des changements temporels d'amplitudes et de fréquences des composantes harmoniques de signal pour générer des données d'analyse représentant le fonctionnement de l'au moins un dispositif électrique (102) ; et
(iii) la configuration de l'au moins une unité de surveillance (104) pour communiquer les données d'analyse à l'agencement de serveur de données (108) pour :
(a) agréger des données d'analyse reçues de l'au moins une unité de surveillance (104) pour obtenir des données d'analyse agrégées ;
(b) générer des résultats de performance agrégés en ce qui concerne l'au moins un dispositif électrique (102) sur la base des données d'analyse agrégées ;
(c) fournir des signaux de commande à l'au moins une unité de surveillance (104) pour surveiller le fonctionnement de l'au moins un dispositif électrique (102) sur la base des résultats de performance agrégés de l'au moins un dispositif électrique (102) ;
(d) générer des alertes relatives à l'au moins un dispositif électrique (102) lorsque les résultats de performance agrégés de l'au moins un dispositif électrique (102) dépassent un niveau de seuil, les alertes représentant au moins l'un parmi : une maintenance requise pour l'au moins un dispositif électrique (102), un remplacement requis pour différentes parties de l'au moins un dispositif électrique (102) ou des causes potentielles pour une défaillance de l'au moins un dispositif électrique (102) ; et
(e) une évaluation de la condition de l'au moins un dispositif électrique (102), dans lequel une condition de l'au moins un dispositif électrique (102) est évaluée sur la base d'une comparaison entre un modèle en temps réel de l'au moins un dispositif électrique (102) généré sur la base des données d'analyse avec un ou plusieurs modèles stockés de l'au moins un dispositif électrique (102),
**caractérisé en ce que** l'agencement de traitement de données de l'au moins une unité de surveillance est configurée pour filtrer au moins partiellement les changements d'amplitudes et de fréquences des composantes harmoniques de signal causées par une distorsion électrique présente dans le spectre de Fourier à changement temporel ;

15. Produit programme informatique comprenant un support de stockage non transitoire lisible par un ordinateur sur lequel sont stockées des instructions lisibles par ordinateur permettant au système selon la revendication 1 d'exécuter toutes les étapes du procédé selon la revendication 14.
